# FASCICULE DE BREVET EUROPEEN

(11) **EP 2 752 893 B1**
(45) Date de publication et mention de la délivrance du brevet: **16.09.2015**
(21) Numéro de dépôt: 13199530.0
(22) Date de dépôt: 24.12.2013
(51) Int. Cl.: H01L 31/107

(54) **Structure semiconductrice du type photodiode à avalanche et procédé de fabrication d'une telle structure**
Halbleiterstruktur vom Typ Lawinen-Fotodiode, und Herstellungsverfahren einer solchen Struktur
Avalanche-photodiode semiconductor structure and method for manufacturing such a structure

(30) Priorité: 31.12.2012 FR 1262990
(43) Date de publication de la demande: 09.07.2014
(73) Titulaire: Commissariat à l'Énergie Atomique et aux Énergies Alternatives, 75015 Paris (FR)
(72) Inventeur: Rothman, Johan, 38000 GRENOBLE (FR)
(74) Mandataire: Ahner, Philippe

(56) Documents cités:
- EP-A2- 0 163 546
- EP-A2- 0 325 532
- ANAND SINGH ET AL: "HgCdTe avalanche photodiodes: A review", OPTICS AND LASER TECHNOLOGY, ELSEVIER SCIENCE PUBLISHERS BV., AMSTERDAM, NL, vol. 43, no. 7, 7 mars 2011 (2011-03-07), pages 1358-1370, XP028384723, ISSN: 0030-3992, DOI: 10.1016/J.OPTLASTEC.2011.03.009 [extrait le 2011-03-10]

## Description

### DOMAINE TECHNIQUE

L'invention se rapporte au domaine des dispositifs de mesure et de détection de lumière.

Ces dernières années, l'application des méthodes de fabrication de la micro-électronique à des matériaux semiconducteurs à gap direct, tels que l'arséniure de gallium et le phosphure d'indium, ont permis d'améliorer les performances des structures optoélectroniques.

Parmi ces structures optoélectroniques, les photodiodes à avalanche ont, entre autre, ainsi vu leur sensibilité améliorée par une baisse du courant d'obscurité. Ces améliorations restent néanmoins insuffisantes pour certaines applications telles que la détection de photons uniques à température ambiante.

Ainsi, la diminution du courant d'obscurité dans les photodiodes à avalanche reste une problématique d'actualité.

L'invention se rapporte donc plus particulièrement à une structure semiconductrice de type photodiode à avalanche et à un procédé de fabrication d'une telle structure.

### ÉTAT DE LA TECHNIQUE ANTÉRIEURE

Les photodiodes à avalanche dédiées à la mesure et à la détection de rayonnement électromagnétique actuellement utilisées présentent généralement une région d'absorption et une région de multiplication de porteurs qui sont distinct l'une de l'autre. De telles photodiodes sont dites à absorption et multiplication séparées.

De telles structures semiconductrices comportent :
- une première zone semiconductrice adaptée pour absorber le rayonnement électromagnétique par génération de paires électron-trou, la première zone étant formée dans une couche semiconductrice qui s'étend longitudinalement,
- une deuxième zone semiconductrice en contact avec la première zone, la deuxième zone étant adaptée pour autoriser lors du fonctionnement de la structure une multiplication des porteurs générés dans la première zone, la deuxième zone étant aménagée dans une deuxième couche semiconductrice qui s'étend le long de la première couche,
- une troisième zone semiconductrice permettant de collecter les porteurs.

Afin d'assurer une bonne délimitation de la zone sur laquelle sont collectés les porteurs et ainsi assurer une reproductibilité des mesures entre les structures, il est connu, notamment par le brevet américain US 7045833, de munir les structures d'un moyen de délimitation de la deuxième zone. Un tel moyen de délimitation permet de limiter la région de la première zone sur laquelle les porteurs générés seront collectés et multipliés par la deuxième zone.

Un tel moyen de délimitation prend la forme d'une gravure des parois latérales de la deuxième zone afin de parfaitement la délimiter latéralement. La deuxième zone présentant des dimensions contrôlées, la région de la première zone dans laquelle sont collectés les porteurs générés est elle-même parfaitement contrôlée. Cette même délimitation permet également de mieux définir dans la deuxième zone le parcours des porteurs générés dans la première zone, et donc d'obtenir un taux de multiplication et un temps de parcours de ces mêmes porteurs qui sont contrôlés. Il en résulte que de telles structures présentent des performances contrôlées et reproductibles avec un temps de réponse bien définit.

Néanmoins, un tel moyen de délimitation est générateur de défauts cristallins qui engendrent un courant d'obscurité non négligeable. Une telle structure comportant un tel moyen de délimitation possède donc un rapport signal sur bruit qui est réduit en raison du courant d'obscurité qui limite donc son application à la mesure et la détection de rayonnement électromagnétique de relativement forte intensité. On peut également ajouter à cela la nécessité d'une lourde étape de gravure afin de graver les parois de la deuxième zone, cette étape complexifiant le procédé de fabrication d'une telle structure.

II est connu du brevet américain US 7348608, pour limiter l'influence de tels défauts cristallins, de former en complément à la gravure latérale de la paroi de la deuxième zone, une zone dite anneau de garde. Un tel anneau de garde a pour but de diminuer le champ électrique notamment au niveau de la paroi de la deuxième zone, en permettant incidemment de réduire le courant de porteurs au niveau de cette même paroi, ceci par la formation une région implantée soit par des éléments dopants soit par des éléments de passivation, tel que de l'hydrogène, adaptés pour rendre semi-isolante la région.

Néanmoins, si un tel anneau de garde permet de limiter l'influence des parois gravées de la deuxième zone, il peut également être à l'origine de courants de fuite qui limitent également le rapport signal sur bruit d'une structure comportant un tel anneau de garde. De plus, l'utilisation combinée d'une gravure des parois de la deuxième zone et d'une région de type anneau de garde engendre un nombre important d'étapes de fabrication.

### EXPOSÉ DE L'INVENTION

La présente invention vise à remédier à ces inconvénients.

L'invention a donc pour but de fournir une structure de type photodiode à avalanche présentant un rapport signal sur bruit amélioré vis-à-vis d'une structure du type photodiode à avalanche comportant un moyen de délimitation latérale de la deuxième zone de l'art antérieur.

A cet effet l'invention concerne une structure semiconductrice de type photodiode à avalanche destinée à recevoir un rayonnement électromagnétique dans une longueur d'onde donnée et comportant :
- une première zone semiconductrice, dite d'absorption, d'un premier type de conductivité présentant une première face destinée à recevoir le rayonnement électromagnétique et une seconde face opposée à la première face, le matériau semiconducteur dans lequel est formée ladite première zone présentant une largeur de bande interdite adaptée pour autoriser l'absorption du rayonnement électromagnétique par ladite première zone,
- au moins une deuxième zone semiconductrice, dite de multiplication, en contact sur une première face longitudinale avec la seconde face de la première zone, la deuxième zone présentant une concentration en porteurs majoritaires inférieure à celle de la première zone, et étant adaptée pour fournir une multiplication des porteurs par ionisation par impact,
- une troisième zone semiconductrice, dite de collecte, en contact avec la deuxième zone semiconductrice, ladite troisième zone étant d'un deuxième type de conductivité opposé au premier type de conductivité et présentant une concentration en porteurs majoritaires supérieure à celle de la deuxième zone semiconductrice,
- un moyen de délimitation adapté pour délimiter la deuxième zone latéralement,
le moyen de délimitation comportant une quatrième zone semiconductrice entourant la deuxième zone et comportant une largeur de bande interdite d'énergie supérieure à celle d'une majeure partie de la deuxième zone, ladite quatrième zone étant du premier type de conductivité.

Un tel moyen de délimitation permet de limiter la deuxième zone sans nécessiter de graver les parois latérales de la deuxième zone, la délimitation étant fournis par une quatrième zone semiconductrice. De plus, une telle quatrième zone permet d'offrir une délimitation électrique de la deuxième zone fournie par une forte concentration en porteurs majoritaires du premier type ceci avec une réduction du courant d'obscurité généré au niveau de cette quatrième zone en raison d'une largeur de bande interdite de ladite quatrième zone augmentée vis-à-vis de celle de la deuxième zone. En effet, avec une telle augmentation de la largeur de bande interdite, on diminue les probabilités de génération thermique de paires électron-trou qui est à l'origine du bruit d'obscurité. Ainsi, une telle structure présente un courant d'obscurité réduit vis-à-vis d'une structure de type photodiode à avalanche de l'art antérieur.

La deuxième zone peut présenter une concentration en porteurs majoritaires au moins inférieure de 10 fois celle de la première zone.

La troisième zone peut présenter une concentration en porteurs majoritaires au moins 10 fois plus importante que celle de la deuxième zone semiconductrice.

La quatrième zone peut présenter une concentration en porteurs majoritaires au moins 10 fois supérieure à celle de la deuxième zone.

La quatrième zone est de préférence en contact avec la première zone.

La délimitation électrique entre les deux zones permet de limiter la capacité de la structure ainsi que d'éviter la diaphonie (plus connue sous sa dénomination anglaise « cross-talk ») entre deux structures adjacentes dans un matrice de photo-détecteurs. Elle permet également d'éviter une concentration du champ électrique au niveau des coins de la deuxième zone, qui pourrait réduire la sensibilité de la structure par une génération de courant tunnel.

On entend par majeure partie de la deuxième zone, une partie de la deuxième zone comportant au moins la moitié, voire les deux tiers ou préférentiellement 90%, de la deuxième zone et pouvant contenir jusqu'à la totalité de la deuxième zone.

La largeur de bande interdite est supérieure à la bande interdite de la deuxième zone d'au moins 0,1 eV et préférentiellement de 0,2 eV.

La deuxième et la quatrième zone peuvent être toutes deux essentiellement formées d'au moins trois même éléments, ces au moins trois éléments étant adaptés de manière à ce que la variation de la proportion d'au moins un desdits au moins trois éléments entraîne une variation de largeur de bande interdite, les proportions respectives dudit au moins un élément de la deuxième et de la quatrième zone étant adaptées pour que la quatrième zone présente une largeur de bande interdite supérieure à celle de la deuxième zone.

Une telle possibilité permet de former la quatrième et la deuxième zone simplement en modifiant la proportion de l'au moins un élément. En plus de simplifier le procédé de fabrication d'une telle structure, une telle possibilité permet, pour des variations de la proportion de l'au moins un élément suffisamment réduites, de limiter les problèmes de défauts d'interface entre ces deux zones et donc de limiter le courant d'obscurité qui est à l'origine de tels défauts.

Les au moins trois éléments peuvent être le tellure, le cadmium et le mercure, la proportion de cadmium de la deuxième et de la quatrième zone étant adaptées pour que la quatrième zone présente une largeur de bande interdite supérieure à celle de la deuxième zone.

On entend ci-dessus et dans le reste de ce document par proportion de cadmium, la proportion x de cadmium dans un tellurure de mercure-cadmium du type CdₓHg₁₋ₓTe avec la valeur x correspondant à la proportion de cadmium par rapport au mercure.

L'utilisation du tellure, du cadmium et du mercure pour former la deuxième et la quatrième zone permet de former ces zones dans des tellurures de mercure-cadmium qui possèdent entre autres avantages de présenter une variation réduite du paramètre de maille même pour des variations importantes de la proportion de cadmium. Une variation réduite du paramètre de maille permet de limiter les défauts cristallins à l'interface entre la quatrième et la deuxième zone. De plus l'utilisation d'une deuxième zone formée dans un tellurure de mercure-cadmium permet de fournir une zone de multiplication de porteurs, cette dernière permettant de multiplier par ionisation par impact sensiblement uniquement les électrons comme l'ont démontré les travaux de J. Rothman et ses co-auteurs publiés dans Journal of Electronic Material N°40, page 1757, publié en 2011. Avec une telle sélectivité de multiplication des porteurs, la structure présente, par rapport à une structure ne présentant pas une telle sélectivité, un meilleur contrôle du taux de multiplication ce qui améliore le rapport du signal sur bruit photonique et réduit le temps de réponse.

La structure peut comporter en outre une couche d'adaptation et une couche de passivation, la couche d'adaptation comportant une partie, dite mineure, de la deuxième zone et étant en contact avec une partie, dite majeure, de la deuxième zone, cette même couche d'adaptation présentant une largeur de bande interdite dont l'énergie est comprise entre celle de la bande interdite de la couche de passivation et celle de la bande interdite de la majeure partie de la deuxième zone.

Une telle couche d'adaptation en complément de la couche de passivation permet de passiver la surface de la structure avec un impact de la couche de passivation sur les caractéristiques électriques de la structure réduit par l'utilisation de la couche d'adaptation qui permet une ouverture de gap graduelle.

La couche d'adaptation peut être formée dans un tellurure de mercure-cadmium du type CdₓHg₁₋ₓTe dont la proportion x en cadmium est supérieure à celle de la majeure partie de la deuxième zone.

L'utilisation d'une couche d'adaptation présentant une proportion de cadmium plus importante que celle de la majeure partie de la deuxième zone autorise la mise en place d'un procédé de fabrication de la structure faisant appel, pour la formation de la quatrième zone, à la diffusion du cadmium de la couche d'adaptation. En effet, avec une telle couche d'adaptation, il est possible de former la quatrième zone directement en implantant à l'arsenic, ou un autre type d'élément dopant favorisant la diffusion du cadmium, les bords latéraux de la partie de la structure qui est destinée à former la quatrième zone et d'effectuer un recuit d'activation de l'arsenic, ou autre élément dopant. Un tel recuit entraîne une diffusion du cadmium de la couche d'adaptation vers la zone implantée augmentant ainsi la proportion de cadmium et par là même la largeur de bande interdite de la partie de la structure implantée. La zone ainsi formée présente, de par l'activation de l'arsenic, ou autre élément dopant, et la diffusion du cadmium, une concentration en porteurs majoritaires et une largeur de bande interdite supérieures à celles de la partie de la structure dans laquelle elle a été formée.

La couche d'adaptation peut comporter au moins une partie de la troisième zone semiconductrice.

La couche d'adaptation peut comporter la totalité de la troisième zone.

Il peut être prévu un premier et un deuxième moyen de polarisation adaptés pour polariser respectivement la troisième et la première zone semiconductrice, le deuxième moyen de polarisation comportant la quatrième zone et un contact électrique en contact électrique avec la quatrième zone, la quatrième zone permettant de connecter électriquement la première zone et le contact électrique.

Avec un tel deuxième moyen, il n'est pas nécessaire de prévoir le contact électrique permettant la polarisation de la première zone directement en contact avec la première zone, celui-ci étant déporté au niveau de la quatrième zone.

Le moyen de délimitation peut comporter en outre une cavité entourant latéralement sur au moins une partie de son épaisseur la deuxième zone, la quatrième zone étant comprise entre la cavité et la deuxième zone.

Une telle cavité permet d'adapter une quatrième zone sur des structures sur lesquelles une étape d'implantation sur toute la hauteur de la structure n'est pas envisageable, telles que par exemple une structure comportant une deuxième zone de forte épaisseur. En effet, l'aménagement d'une cavité dans la structure préalablement à une étape d'implantation afin de former la quatrième couche permet de réduire l'épaisseur de la structure qui doit être implantée puisque seule une faible épaisseur autour de la périphérie de la cavité doit l'être.

La deuxième zone peut être adaptée pour fournir une multiplication de porteurs par ionisation par impact qui est prépondérante pour un type de porteurs et négligeable pour l'autre type de porteurs, et la deuxième zone peut comporter au moins deux sous-parties de sa majeure partie, la première sous-partie par laquelle la deuxième zone est en contact avec la première zone, la deuxième sous-partie étant adaptée pour présenter un taux moyen de multiplication de porteurs par micromètre supérieur au taux moyen de multiplication de porteurs par micromètre de la première sous-partie, et préférentiellement supérieur à 3 fois, 5 fois, voire 10 fois le taux moyen de multiplication de porteurs par micromètre de la première sous-partie.

Ainsi, les porteurs générés dans la première zone, lors de leur transit vers la troisième zone, traversent tour à tour la première sous-partie et la deuxième sous-partie. La première sous-partie en présentant un taux de multiplication par micromètre réduit permet d'augmenter le courant de porteurs avec un rapport signal sur bruit contenu. Le courant de porteurs est ainsi faiblement augmenté avec un rapport signal sur bruit qui reste contenu. Le courant de porteurs transite ensuite par la deuxième sous-partie dans laquelle il est significativement augmenté par le fort taux de multiplication par micromètre que présente la deuxième sous-partie.

On entend ci-dessus et dans le reste de ce document, par taux moyen de multiplication de porteurs par micromètre dans l'une de la première et de la deuxième zone, le taux de multiplication par micromètre dans ladite zone lorsque la structure est en fonctionnement, c'est-à-dire lorsqu'elle est polarisée sous une tension nominale de fonctionnement tel que par exemple 12 V.

La deuxième zone peut être adaptée pour fournir une multiplication de porteurs par ionisation par impact qui est prépondérante pour un type de porteurs et négligeable pour l'autre type de porteurs, et la deuxième zone peut comporter au moins deux sous-parties de sa majeure partie, la première sous-partie par laquelle la deuxième zone est en contact avec la première zone, la deuxième sous-partie étant adaptée pour présenter un taux de multiplication de porteurs supérieur au taux de multiplication de porteurs de la première sous-partie, et préférentiellement supérieur à 3 fois, 5 fois, voire 10 fois le taux de multiplication de porteurs de la première sous-partie, la première et la deuxième partie présentant une épaisseur du même ordre de grandeur.

On entend ci-dessus et dans le reste de ce document, par taux de multiplication de porteurs dans l'une de la première et de la deuxième zone, le taux de multiplication dans ladite zone lorsque la structure est en fonctionnement, c'est-à-dire lorsqu'elle est polarisée sous une tension nominale de fonctionnement tel que par exemple 12 V.

Le bruit d'obscurité généré dans cette deuxième sous-partie, s'il est significativement important vis-à-vis de celui généré dans la première sous-partie, reste réduit par rapport au courant de porteurs après qu'il ait été augmenté par son passage dans la première sous-partie. Ainsi, la structure présente un taux de multiplication par micromètre important du courant de porteurs, qui est le produit de celui de la première sous-partie et de celui de la deuxième sous-partie, avec un rapport signal sur bruit qui reste contenu et qui est de l'ordre du rapport signal sur bruit en sortie de la première sous-partie. Une telle structure présente ainsi une sensibilité améliorée vis-à-vis d'une structure selon l'art antérieur.

La deuxième sous-partie peut être réalisée dans un matériau semiconducteur présentant une largeur de bande interdite inférieure à celle du matériau semiconducteur dans lequel est formée la première sous-partie de manière à présenter un taux moyen de multiplication de porteurs par micromètre supérieur à celui de la première sous-partie.

Une telle variation de la largeur de bande interdite entre la première et la seconde sous-partie de la deuxième zone permet de fournir une première et une deuxième sous-partie avec des taux moyen de multiplication de porteurs par micromètre différents l'une de l'autre.

La première et la deuxième sous-partie peuvent être réalisées dans des tellurures de mercure-cadmium du type CdₓHg₁₋ₓTe avec des proportions x en cadmium différentes l'une de l'autre.

Une première et une deuxième sous-partie réalisées dans des tellurures de mercure-cadmium permettent de fournir une majeure partie de la deuxième zone qui, tout en présentant une multiplication de porteurs par ionisation par impact qui est prépondérante pour les électrons avec la deuxième sous-partie qui présente une largeur de bande interdite inférieure à celle de la première sous-partie, comporte une interface entre la première et la deuxième sous-partie sensiblement exempte de défauts cristallins. En effet, les tellurures de mercure-cadmium permettent une variation importante de la largeur de bande interdite en variant la proportion de cadmium sans variation significative des paramètres de maille cristallins.

La première et la deuxième sous-partie peuvent présenter des concentrations en porteurs majoritaires sensiblement identiques.

La première et la deuxième sous-partie de la première zone peuvent présenter le deuxième type de conductivité.

La première sous-partie peut présenter le premier type de conductivité, la deuxième sous-partie présentant le deuxième type de conductivité.

La première et la deuxième sous-partie peuvent présenter le premier type de conductivité.

La première et la deuxième sous-partie peuvent être réalisées dans le même matériau semiconducteur et étant du deuxième type de conductivité avec une concentration en porteurs majoritaires du même ordre de grandeur, la première et la deuxième sous-partie étant séparées l'une de l'autre par une zone d'interface du premier type de conductivité dont la concentration en porteurs majoritaires est adaptée pour modifier la répartition du champ électrique dans la deuxième sous partie afin que cette dernière présente un taux moyen de multiplication de porteurs par micromètre supérieur à celui de la première sous partie, le taux moyen de multiplication de porteurs par micromètre étant préférentiellement supérieur d'au moins 3 fois et préférentiellement 5 fois, voire 10 fois, celui de la première sous-partie.

Les taux moyens de multiplication de porteurs par micromètre différents pour la première et la deuxième sous-partie dans une telle structure sont ainsi obtenus sans nécessiter d'utiliser des matériaux différents pour former les deux sous-parties, ce qui limite les risques d'apparition de défauts cristallins à l'interface de ces deux sous-parties, ce type de défauts étant généralement lié à une interface entre deux matériaux présentant une différence importante de mailles cristallines.

Le matériau semiconducteur dans lequel est formée la première zone peut être un tellurure de mercure-cadmium dont la composition en cadmium est variée pour favoriser l'absorption du rayonnement, et dans laquelle la première zone comporte un élément dopant fournissant au moins un porteur majoritaire correspondant au premier type de conductivité, la concentration en ledit élément dopant étant variée alternativement dans une direction sensiblement perpendiculaire à la première face longitudinale entre une concentration dite faible et une concentration dite forte.

L'utilisation d'une première zone comportant une concentration en l'élément dopant qui est variée alternativement dans une direction sensiblement perpendiculaire à la première face longitudinale permet d'assurer que la diffusion du cadmium dans ladite première zone pendant le recuit d'activation de l'élément dopant est restée faible puisque cette diffusion est directement reliée aux fortes concentrations en l'élément dopant. Ainsi, les parties de la première zone qui présentent une telle configuration de dopage font office de barrière à la diffusion du cadmium et permettent à la structure de présenter une proportion en cadmium qui est variée le long de la direction sensiblement perpendiculaire malgré l'utilisation de l'élément dopant.

L'élément dopant fournissant au moins un porteur majoritaire peut être l'arsenic.

L'élément dopant fournissant au moins un porteur majoritaire peut être l'or Au ou encore l'antimoine Sb.

La première zone peut comporter une proportion x en cadmium qui est diminuée en direction de la deuxième zone le long d'un axe sensiblement perpendiculaire à la première face longitudinale.

Une telle variation de la proportion x de cadmium dans la première zone permet de créer un champ électrique le long de la première zone. Ce champ électrique dans la première zone a pour effet d'accélérer la diffusion de porteurs en direction de la deuxième zone et permet donc de diminuer le temps de réponse de la structure par rapport à une structure ne présentant pas une telle variation de la proportion x de cadmium.

La concentration faible en l'élément dopant peut être sensiblement nulle.

Une telle concentration faible permet de limiter les risques de diffusion du cadmium lors du recuit d'activation dans les parties de la première zone comportant la concentration faible en l'élément dopant. Ainsi, la structure peut comporter une variation de la proportion x de cadmium dans la première zone au moins au niveau des parties de cette première zone comportant la concentration faible en l'élément dopant.

L'alternance entre la concentration faible et la concentration forte dans la première zone peut être sensiblement périodique.

Chaque période peut comporter une première partie correspondant à la concentration forte et une deuxième partie correspondant à la concentration faible, le rapport dimensionnel entre la première partie et la deuxième partie selon la direction sensiblement perpendiculaire à la face longitudinale étant au maximum de 10.

Un tel rapport dimensionnel entre la première et la deuxième partie de chaque période permet d'assurer une faible résistance série. En effet, avec un tel rapport dimensionnel, les porteurs majoritaires fournis par la deuxième zone permettent d'assurer une bonne conduction à la fois dans la deuxième partie et dans la première partie assurant une conduction sur toute l'épaisseur de la première zone.

La première zone peut être en contact avec la deuxième zone par une région sensiblement dépourvue d'élément dopant.

La région de la première zone par laquelle la première zone est en contact avec la deuxième zone peut comporter une proportion x en cadmium qui est variée en direction de la deuxième zone.

L'invention concerne également un procédé de fabrication d'une structure du type photodiode à avalanche, ledit procédé comportant les étapes consistant à :
- fournir un support comportant une première zone semiconductrice d'un premier type de conductivité présentant une première face destinée à recevoir le rayonnement électromagnétique et une seconde face opposée à la première face, le matériau semiconducteur dans lequel est formée ladite première zone présentant une largeur de bande interdite adaptée pour autoriser l'absorption du rayonnement électromagnétique dans ladite première zone,
- former au moins une deuxième zone semiconductrice en contact sur une première face longitudinale avec la seconde face de la première zone, la deuxième zone présentant une concentration en porteurs majoritaires au moins inférieure à celle de la première zone,
- former une troisième zone semiconductrice en contact avec la deuxième zone semiconductrice, ladite troisième zone étant d'un deuxième type de conductivité opposé au premier type de conductivité et présentant une concentration en porteurs majoritaires supérieure à celle de la deuxième zone semiconductrice,
- former une quatrième zone semiconductrice entourant la deuxième zone et comportant une largeur de bande interdite supérieure à la largeur de bande interdite de la majeure partie de la deuxième zone, ladite quatrième zone étant du premier type de conductivité avec une concentration en porteurs majoritaires supérieure à celle de la deuxième zone, ladite quatrième zone formant un moyen de délimitation de la deuxième zone.

Un tel procédé de fabrication permet de fabriquer une structure semiconductrice du type photodiode présentant un rapport signal sur bruit amélioré vis-à-vis d'une structure du type diode à avalanche de l'art antérieur.

Lors de l'étape de formation de la quatrième zone, la quatrième zone peut être formée de manière à entourer totalement la deuxième zone.

La structure peut comporter une couche d'adaptation, et les première et quatrième zones ainsi que la couche d'adaptation étant formées dans des tellurures de mercure-cadmium du type CdₓHg₁₋ₓTe et l'étape de formation de la deuxième zone peut comporter les sous-étapes consistant à :
- former la couche d'adaptation en contact avec une majeure partie de la deuxième zone semiconductrice, la proportion x de cadmium étant adaptée pour que la couche d'adaptation présente une largeur de bande interdite supérieure à celle de la deuxième zone,
- implanter les portions de la structure destinée à former la quatrième zone avec de l'arsenic de manière à fournir une concentration en porteurs majoritaires supérieure à celle de la deuxième zone semiconductrice,
- faire un recuit d'activation de manière à faire diffuser une partie du cadmium à partir de la couche d'adaptation dans lesdites portions de la structure de manière à former la quatrième zone.

Un tel procédé permet la formation d'une structure semiconductrice du type photodiode avec un moyen de délimitation latérale de la deuxième zone formé avec un procédé simple à mettre en oeuvre, la formation de la quatrième zone étant obtenue par une seule étape d'implantation à l'arsenic et un recuit d'activation de l'arsenic.

L'étape de fourniture de la deuxième zone peut comporter une sous-étape consistant à former une majeure partie de la deuxième zone en contact avec la première zone, la majeure partie comportant une première sous-partie par laquelle la deuxième zone est en contact avec la première zone et une deuxième sous-partie reliant la première sous-partie à la troisième zone, la deuxième sous-partie étant adaptée pour présenter un taux moyen de multiplication de porteurs par micromètre supérieur au taux moyen de multiplication de porteurs par micromètre de la première sous-partie, et préférentiellement supérieur à 3 fois, 5 fois, voire 10 fois le taux moyen de multiplication de porteurs par micromètre de la première sous-partie.

Une telle étape de fourniture de la deuxième partie permet de fournir une photodiode à avalanche qui possède un rapport signal sur bruit augmenté vis-à-vis d'une structure présentant un gain de multiplication de porteurs identique et comportant une deuxième partie réalisée selon l'étape de formation d'une deuxième partie selon de l'art antérieur.

L'étape de fourniture du support avec la première zone peut consister notamment à fournir une première zone semiconductrice d'un premier type de conductivité présentant une première face longitudinale destinée à recevoir le rayonnement électromagnétique et une seconde face opposée à la première face, ladite première zone étant en tellurure de mercure-cadmium de type CdₓHg₁₋ₓTe avec une proportion x de cadmium qui est variée, la première zone comportant un élément dopant dont la concentration est variée alternativement dans une direction sensiblement perpendiculaire à la face longitudinale entre une concentration dite faible et une concentration dite forte.

Une telle étape de fourniture du support permet de fournir une structure avec une première couche qui malgré l'utilisation de l'élément dopant présente une proportion de cadmium qui est variée.

L'élément dopant peut être l'arsenic.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une vue en coupe transversale d'une structure selon un premier mode de réalisation dans lequel la structure comporte une troisième zone semiconductrice qui n'est pas incluse dans la couche d'adaptation,
- la figure 2 illustre une vue en coupe transversale d'une structure selon un deuxième mode de réalisation dans lequel la troisième zone semiconductrice est incluse dans la couche d'adaptation,
- la figure 3 illustre une vue en coupe transversale d'une structure selon un troisième mode de réalisation dans lequel la structure comporte une quatrième zone adaptée pour polariser la zone d'absorption,
- la figure 4 illustre une vue en coupe transversale d'une structure selon un quatrième mode de réalisation dans lequel la structure comporte une cavité latérale qui est prolongée par la quatrième zone,
- la figure 5 illustre une vue en coupe transversale d'une structure selon un cinquième mode de réalisation dans lequel la structure comporte une deuxième zone dont la majeure partie comprend deux sous-parties,
- la figure 6 illustre graphiquement la variation du taux de multiplication d'une zone de multiplication en tellurure de mercure-cadmium d'une structure ceci en fonction à la fois de la tension de polarisation de la structure et de la fréquence de coupure de la deuxième couche semiconductrice, elle est extraite d'un article de J. Rothman et Al. publié dans la revue scientifique Journal of « Electronic Materials » n°42 p2928 en 2012 ;
- la figure 7 illustre une vue en coupe transversale d'une structure selon un sixième mode de réalisation dans lequel la structure comporte une première zone semiconductrice adaptée pour absorber un rayonnement électromagnétique sur une gamme de longueurs d'ondes élargie,
- La figure 8 illustre sous la forme d'un graphique la variation de la concentration en arsenic et de la proportion en cadmium dans la première zone d'une structure telle qu'illustrée sur la figure 6.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

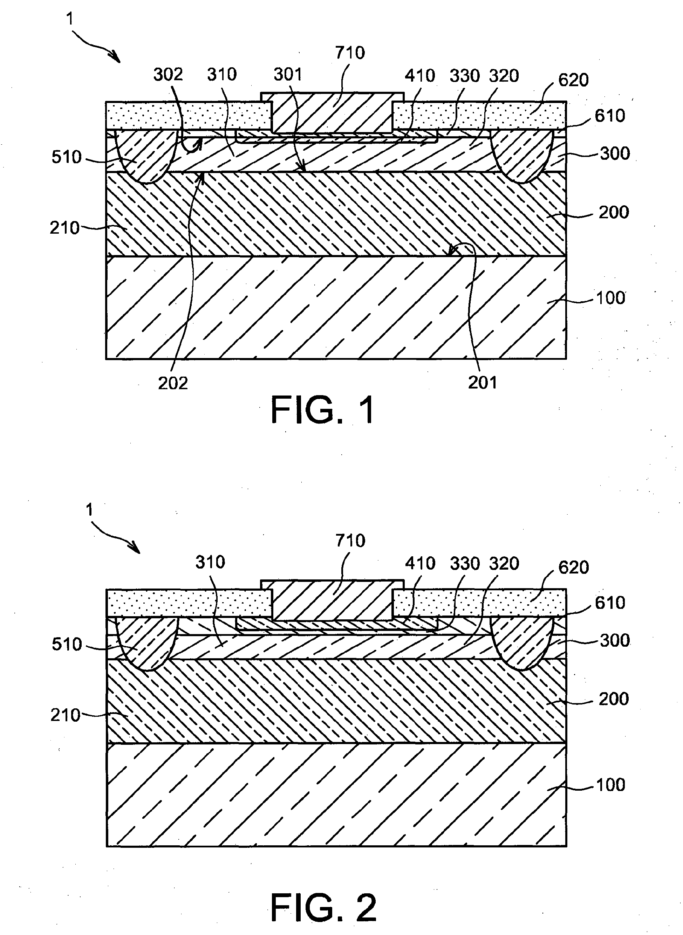

La figure 1 illustre une structure 1 semiconductrice selon un premier mode de réalisation, ladite structure 1 étant destinée à la détection et la mesure d'un rayonnement électromagnétique dont la longueur d'onde est comprise dans une gamme de longueurs d'ondes donnée.

Afin d'illustrer et de faciliter la compréhension du fonctionnement de l'invention, les valeurs et les matériaux qui sont cités ci-dessus, quand cela est précisé, concernent une application particulière de l'invention à la détection et à la mesure de rayonnements électromagnétiques dont la longueur d'onde est comprise dans la gamme de longueurs d'ondes du proche infrarouge. Bien entendu, les valeurs et les matériaux concernant cette application ne sont donnés qu'à titre d'illustration et ne sont pas limitatifs.

On entend ci-dessus et dans le reste de ce document par gamme de longueurs d'ondes du proche infrarouge une gamme de longueurs d'ondes comprise entre 1,5 µm et 5 µm.

Une structure 1 selon le premier mode de réalisation de l'invention comporte :
- un support 100,
- une première zone 210 semiconductrice d'un premier type de conductivité présentant une première face 201 destinée à recevoir le rayonnement électromagnétique et une seconde face 202 opposée à la première face 201, ladite première zone 210 comportant une largeur de bande interdite adaptée pour favoriser l'absorption du rayonnement électromagnétique dans la gamme de longueurs d'onde donnée,
- une deuxième zone 310 semiconductrice en contact par une première face longitudinale 301 avec la seconde face 202 de la première zone 210,
- une troisième zone 410 semiconductrice en contact avec la deuxième zone 310 semiconductrice, ladite troisième zone 410 étant d'un deuxième type de conductivité opposé au premier type de conductivité,
- une quatrième zone 510 semiconductrice entourant la deuxième zone 310 et comportant une largeur de bande interdite supérieure à celle de la deuxième zone 310, ladite quatrième zone 510 étant du premier type de conductivité,
- un contact électrique 710 en contact avec la troisième zone 410 et adapté pour polariser la troisième zone 410, le contact électrique formant un premier moyen de polarisation,
- un deuxième moyen de polarisation, non illustré, adapté pour polariser la première zone,
- une couche d'adaptation 610 en contact avec la majeure partie 320 de la deuxième zone 310 et comportant une partie de la troisième zone 410,
- une couche de passivation 620 en contact avec la couche d'adaptation 610.

Le support 100 est un support adapté pour la formation de la première zone 210 et est au moins partiellement transparent dans la gamme de longueurs d'ondes donnée. Ainsi le support 100 peut être réalisé dans un matériau isolant ou semiconducteur dont la largeur de bande interdite est adaptée pour être supérieure à l'énergie des photons d'un rayonnement électromagnétique dont la longueur d'onde est dans la gamme de longueurs d'ondes donnée.

Dans l'application particulière le support 100 peut être réalisé en tellurure zinc-cadmium CdZnTe. En effet, le matériau tellurure zinc-cadmium CdZnTe présente une énergie de bande interdite d'au moins 1,4 eV, et est donc transparent aux infrarouges et peu sensible au bruit thermique.

Le support 100 présente une première et une seconde face, la première face étant la face qui est destinée à recevoir le rayonnement électromagnétique.

La structure 1 comporte en outre une première couche 200 semiconductrice en contact avec le support 100. La première couche 200 est réalisée dans un matériau semiconducteur dont la largeur de bande interdite est adaptée pour autoriser l'absorption des rayonnements électromagnétiques dont la longueur d'onde est comprise dans la gamme de longueurs d'ondes donnée. Ainsi la première couche 200 dans un matériau semiconducteur comportant une largeur de bande interdite dont l'énergie est inférieure à l'énergie des photons d'un rayonnement électromagnétique dont la longueur d'onde est comprise dans la gamme de longueurs d'ondes donnée.

La première couche 200 est d'un premier type de conductivité. Le premier type de conductivité est choisi parmi le type de conductivité pour lequel les porteurs majoritaires sont des électrons et le type de conductivité pour lequel les porteurs majoritaires sont des trous.

L'épaisseur de la première couche 200 est adaptée pour qu'une majeure partie d'un rayonnement reçu par la première face de la structure 1 au niveau de la première zone 210 soit absorbée par la première zone 210.

Dans l'application particulière, la première couche 200 est formée dans un tellurure de mercure-cadmium CdₓHg₁₋ₓTe dont la proportion en cadmium x est comprise entre 0,33 et 0,6. Avec une proportion de cadmium de 0,33 et 0,6, la première couche est adaptée pour absorber à une température de 300 K un rayonnement électromagnétique dans une gamme de longueurs d'ondes respectivement inférieure à 3,7 µm et à 1,8 µm.

Dans cette même application particulière, le premier type de conductivité est du type de conductivité pour lequel les porteurs majoritaires sont des trous. La concentration en porteurs majoritaires dans la première couche 200 est préférentiellement comprise entre 10¹⁶ et 10¹⁷ cm⁻³. Selon cette application, la première couche 200 présente une épaisseur comprise entre 0,5 et 2 µm. La première couche, afin d'obtenir le premier type de conductivité comporte des éléments dopants, tel que l'arsenic As, l'or Au ou encore l'antimoine Sb, adaptés pour fournir au moins un porteur correspondant au premier type de conductivité lorsqu'ils sont activés.

La partie de la première couche 200 dans laquelle sont générées les paires électron-trou qui sont à l'origine du signal de la structure forme la première zone 210 de la structure 1.

La première couche 200 présente une première et une seconde face 201, 202, la première face 201 étant la face par laquelle la première couche 200 est en contact avec le support 100. La première couche 200 est en contact par sa seconde face 202, qui est opposée à sa première face 201, avec une deuxième couche 300 semiconductrice. La deuxième couche 300 comporte une première face 301 longitudinale par laquelle elle est en contact avec la seconde face 202 de la première couche 200.

La deuxième couche 300 est une couche semiconductrice dont une portion forme la majeure partie 320 de la deuxième zone 310, dite de multiplication. La portion de la deuxième couche 300 qui forme la majeure partie 320 de la deuxième zone 310 est ainsi adaptée pour, lors du fonctionnement de la structure 1, former une couche multiplicatrice de porteurs. Pour obtenir une telle adaptation, la portion de la deuxième couche 300 semiconductrice qui forme la majeure partie 320 de la deuxième zone 310 comporte une concentration en porteurs majoritaires qui est au moins 10 fois inférieure à celle de la première zone 210 et préférentiellement 50 fois inférieure. La deuxième couche 300, en fonction des contraintes de fonctionnement de la structure 1 peut être du premier type de conductivité ou d'un deuxième type de conductivité qui est opposé au premier type de conductivité.

Selon une autre possibilité de l'invention, la portion de la deuxième couche 300 qui forme la majeure partie 320 de la deuxième zone 310 peut être du type intrinsèque ou du type non intentionnellement dopé.

On entend par du « type intrinsèque » que la partie de la deuxième couche 300 qui forme partiellement la deuxième zone 310 comporte une concentration en porteurs d'un premier type qui est sensiblement identique à la concentration en porteurs d'un deuxième type qui est opposé au premier type de porteurs.

On entend par du « type non intentionnellement dopée » que la concentration en porteurs majoritaires dans la portion de la deuxième couche 300 qui forme la majeure partie 320 de la deuxième zone 310 est la concentration correspondant à un matériau dans lequel on n'a pas intentionnellement introduit d'éléments dopants, c'est-à-dire d'éléments adaptés pour fournir des porteurs. La concentration en porteurs majoritaires et le type de conductivité d'une zone du type non intentionnellement dopé sont liés au procédé de formation de ladite zone.

La deuxième couche 300, au moins pour sa portion qui forme la majeure partie 320 de la deuxième zone 310, présente une largeur de bande interdite qui est adaptée afin d'optimiser lors du fonctionnement de la structure 1 le taux de multiplication des porteurs lors de leur transit dans ladite deuxième couche 310, ceci pour au moins un type de porteurs.

De même, l'épaisseur de la deuxième couche 300 est suffisamment importante pour que la structure 1 présente un taux de multiplication des porteurs générés dans la première couche 200 adapté pour fournir un signal mesurable.

Dans l'application particulière, la portion de la deuxième couche 300 qui forme la majeure partie 320 de la deuxième zone 310 est réalisée dans un tellurure de mercure-cadmium CdₓHg₁₋ₓTe dont la proportion en cadmium x est comprise entre 0,42 et 0,2 et préférentiellement comprise entre 0,32 et 0,2 pour fournir une deuxième gamme de longueurs d'ondes comprenant le rayonnement thermique. Dans cette même application particulière, la deuxième couche 300, au moins sur sa portion formant la majeure partie 320 de la deuxième zone 310, est d'un type de conductivité opposé à celui de la première zone 210 et est donc un type de conductivité dans lequel les porteurs majoritaires sont des électrons. La concentration en porteurs majoritaires de la portion de la deuxième couche 300 formant la majeure partie 320 de la deuxième zone 310 est comprise entre 10¹⁴ et 10¹⁵ cm⁻³. La concentration en porteurs majoritaires de la portion de la deuxième couche 300 formant la majeure partie 320 de la deuxième zone 310 est donc effectivement inférieure à celle de la première zone 210, ici dix fois inférieure, ou dix fois plus petite.

On entend ci-dessus par rayonnement thermique la gamme de longueurs d'ondes des infrarouges moyens à lointains comprises entre 3 et 10 µm.

Selon cette même application particulière, l'épaisseur de la deuxième couche 300 est comprise entre 0,5 et 2 µm.

La deuxième couche 300 semiconductrice comporte en outre la majeure partie de la quatrième zone semiconductrice 510. La quatrième zone 510 entoure et délimite latéralement la deuxième zone 310.

La deuxième couche 300 semiconductrice comporte une seconde face 302 qui est opposée à la première face longitudinale 301. La deuxième couche 300 est en contact par sa deuxième face 302 avec la couche d'adaptation 610.

La couche d'adaptation 610 est une troisième couche semiconductrice qui est adaptée pour former une bonne interface entre la deuxième couche 300 semiconductrice et la couche de passivation 620. A cet effet, la couche d'adaptation 610 présente, à l'exception de sa portion comportant la quatrième zone 510, une largeur de bande interdite intermédiaire entre celle de la majeure partie 320 de la deuxième zone 310 et la largeur de bande interdite de la couche de passivation 620.

La couche d'adaptation 610, à l'exclusion de sa portion formant une partie de la quatrième zone 510 est du deuxième type de conductivité. La couche d'adaptation 610 comporte, à l'exclusion de sa portion formant la troisième zone 410 semiconductrice et d'une portion formant une partie de la quatrième zone 510, une concentration en porteurs majoritaires qui est du même ordre de grandeur que celle de la majeure partie 320 de la deuxième zone 310 et préférentiellement sensiblement égale à celle de la majeure partie 320 de la deuxième zone 310. Ainsi la couche d'adaptation 610 comporte une partie minoritaire 330 de la deuxième zone 310 semiconductrice par laquelle la deuxième zone 310 est en contact avec la couche de passivation.

La deuxième zone 310 de multiplication est essentiellement formée de la portion 320 de la deuxième couche 300 située entre les quatrièmes zones 510 de délimitation latérale, nommée majeure partie 320 de la deuxième zone 310. Elle peut également comprendre une portion 330 de la couche d'adaptation 610 nommée mineure partie 330 de la deuxième zone 310.

Dans l'application particulière, la couche d'adaptation 610 est formée dans un tellurure de mercure-cadmium CdₓHg₁₋ₓTe dont la proportion en cadmium x est comprise entre 0,7 et 0,4. Dans cette même application particulière la couche d'adaptation 610, à l'exclusion de sa partie formant une part de la quatrième zone 510, est du même type de conductivité que celui de la deuxième zone 310 et est donc d'un type de conductivité pour lequel les porteurs majoritaires sont des électrons. La concentration en porteurs majoritaires est sensiblement égale à celle de la deuxième zone 310 et est donc comprise entre 10¹⁴ et 10¹⁵ cm⁻³.

La couche d'adaptation 610 comporte une part de la troisième zone semiconductrice 410. La troisième zone 410 est partiellement formée dans la deuxième couche 300, en contact avec la deuxième zone 310, le reste de la troisième zone 410 étant compris dans la couche d'adaptation 610. La troisième zone 410 présente une largeur de bande interdite variable correspondant à celle des couches dans lesquelles elle est formée.

Selon une possibilité de l'invention non illustrée, la couche d'adaptation 610 peut comporter une composition telle que la couche d'adaptation présente une largeur de bande interdite augmentant graduellement en direction de la couche de passivation 620. Une telle possibilité est particulièrement avantageuse en ce qu'elle permet de limiter la présence de défauts entre la deuxième couche 300 et la couche de passivation 620.

La couche d'adaptation 610 comporte en outre une partie de la quatrième zone 510.

La quatrième zone 510 s'étend sur toute l'épaisseur de la deuxième couche 300 et de la couche d'adaptation 610. La quatrième zone 510 est en contact avec la première couche 200 semiconductrice.

La quatrième zone 510 semiconductrice est une zone semiconductrice qui présente une largeur de bande interdite supérieure à celle de la majeure partie de la deuxième zone. La quatrième zone 510 est du premier type de conductivité et présente une concentration en porteurs majoritaires qui est au moins 10 fois plus importante que celle de la deuxième zone semiconductrice.

Selon une possibilité avantageuse de l'invention, la concentration en porteurs majoritaires de la quatrième zone 510 est supérieure à 50 fois celle de la deuxième zone 310.

Selon une possibilité avantageuse de l'invention, la largeur de bande interdite de la quatrième zone 510 est supérieure à celle de la majeure partie 320 de la deuxième zone 310 d'au moins 0,1 eV et préférentiellement à 0,2 eV.

Dans l'application particulière, la quatrième zone 510 est formée dans un tellurure de mercure-cadmium CdₓHg₁₋ₓTe avec une proportion en cadmium qui est comprise entre 0,6 et 0,4. Dans cette même application, la quatrième zone 510 présente une conductivité du type dans lequel les porteurs majoritaires sont des trous avec une concentration en porteurs majoritaires comprise entre 5.10¹⁷ et 10¹⁸ cm⁻³. Selon l'application particulière l'élément dopant qui fournit les porteurs majoritaires dans la quatrième zone 510 est l'arsenic (As).

La quatrième zone 510 forme un moyen de délimitation de la deuxième zone 310 adapté pour délimiter la deuxième zone 310 latéralement.

La couche d'adaptation 610 comporte également une partie de la troisième zone 410 semiconductrice. La troisième zone 410 comporte également une partie dans la deuxième couche 300 semiconductrice par laquelle elle est en contact avec la majeure partie 320 de la deuxième zone 310.

La troisième zone 410 est du deuxième type de conductivité. La troisième zone 410 comporte une concentration en porteurs majoritaires au moins 10 fois, et préférentiellement 50 fois, plus importante que celle de la deuxième zone 310.

La troisième zone 410 est séparée de la quatrième zone 510 par la deuxième zone 310. Préférentiellement, la dimension minimum de l'espace formé par la deuxième zone 310 afin de séparer la troisième zone 410 et la quatrième zone 510 est adaptée pour limiter les interactions électriques entre ces deux mêmes zones 410, 510.

Ainsi, en ce qui concerne l'application particulière, la deuxième zone 310 est adaptée pour former entre la troisième zone 410 de la quatrième zone 510 une séparation qui est typiquement supérieure à 2 µm. Selon cette même possibilité, la séparation formée par la deuxième zone 310 entre la troisième zone 410 et la quatrième zone est généralement inférieure à 10 µm.

Dans l'application particulière, la troisième zone 410 présente le même type de conductivité que celui de la deuxième zone 310. La concentration en porteurs majoritaires est comprise entre 10¹⁶ et 10¹⁸ cm⁻³.

La couche d'adaptation 610 est en contact sur sa face qui est opposée à la deuxième couche 300 avec la couche de passivation 620.

La couche de passivation 620 s'étend le long de la couche d'adaptation 610. La couche de passivation 620 est préférentiellement formée dans un matériau isolant, tel que par exemple l'oxyde de silicium.

La couche de passivation 620 présente une ouverture traversante en communication avec la partie de la couche d'adaptation 610 comportant la troisième zone 410.

Dans l'application particulière, la couche de passivation 620 est réalisée en sulfure de zinc ZnS.

Le contact électrique 710 est en contact avec la troisième zone 410 au travers de l'ouverture aménagée dans la couche de passivation 620.

Le contact électrique 710 est formé dans un matériau conducteur, généralement métallique, adapté pour former un contact ohmique avec la troisième zone 410 semiconductrice.

On peut enfin noter que la structure 1 comporte également, bien que cela ne soit pas illustré sur la figure 1, un deuxième moyen de polarisation, qui peut être un contact électrique traversant les couches de passivation 620, d'adaptation 610 et la deuxième couche 300 semiconductrice pour être en contact électrique avec la première couche 200 semiconductrice. La première couche 200 semiconductrice présentant généralement une concentration en porteurs majoritaires suffisante pour la rendre conductrice, la structure 1 étant une structure parmi une pluralité, le deuxième moyen peut être un deuxième contact électrique collectif adapté pour polariser plusieurs des structures.

Une telle structure 1, lorsqu'elle est une structure selon l'application particulière, peut être formée par un procédé de fabrication comportant les étapes consistant à :
- fournir un support 100 semiconducteur et la première couche 200 semiconductrice, la première couche 200 semiconductrice étant du premier type de conductivité et comportant une première et une seconde face 201, 202, la première couche comportant une première zone 210 semiconductrice,
- former en contact avec la deuxième face 202 de la première couche 200 la deuxième couche 300 semiconductrice, la deuxième couche 300 étant du deuxième type de conductivité et comportant une première et une seconde face 301, 302, la deuxième couche 300 étant en contact avec la première couche 200 par sa première face longitudinale 301, la deuxième couche 300 comportant une majeure partie 320 d'une deuxième zone 310 semiconductrice,
- former la couche d'adaptation 610 en contact avec la deuxième face 302 de la deuxième couche 300 semiconductrice, la couche d'adaptation 610 étant du deuxième type de conductivité et comportant une première et une seconde face, la couche d'adaptation 610 étant en contact avec la deuxième couche 300 par sa seconde face longitudinale 302, la couche d'adaptation 610 comportant une mineure partie 330 de la deuxième zone 310 et permettant ainsi de former, avec la partie 320 de la deuxième couche 300, la deuxième zone 310,
- implanter sélectivement les parties de la couche d'adaptation 610 et de la deuxième couche 300 semiconductrice destinées à former la quatrième zone 510 par de l'arsenic (As) de manière à ce que la quatrième zone 510 présente le premier type de conductivité, cette implantation est préférentiellement réalisée de manière à entourer totalement la deuxième zone 310, c'est-à-dire à être en contact avec la deuxième couche 200,
- effectuer un recuit à une température suffisante pour activer l'arsenic afin de libérer les porteurs majoritaires, un tel recuit ayant pour conséquence une diffusion dans la quatrième zone 510 d'une partie du cadmium présent dans la première couche 200 semiconductrice et dans la couche d'adaptation 610, de manière à augmenter ainsi la largeur de bande interdite dans les portions destinées à former la quatrième zone 510, ce qui permet de former la quatrième zone 510,
- former la couche de passivation 620 sur la face de la couche d'adaptation 610 qui est opposée à la deuxième couche 300 semiconductrice,
- implanter sélectivement avec des éléments dopants les portions de la couche d'adaptation 610 et de la deuxième couche 300 semiconductrice qui sont destinées à former la troisième zone 410 semiconductrice et former ainsi la troisième zone 410 semiconductrice,
- former dans la couche de passivation 620 une ouverture traversante en communication avec la troisième zone 410 semiconductrice,
- former le contact électrique 710 au travers de l'ouverture de la couche de passivation 620 et en contact électrique avec la troisième zone 410 semiconductrice,
- former le deuxième moyen de polarisation adapté pour polariser la première zone 210 semiconductrice.

En fonctionnement, la structure 1 est fortement polarisée en inverse, c'est-à-dire que pour une première et une troisième zone 210, 410 présentant chacune un type de conduction dans lequel les porteurs majoritaires sont respectivement des trous et des électrons, la première zone 210 est fortement polarisée négativement vis-à-vis de la troisième zone 410. Ainsi, la jonction semiconductrice se trouvant à l'interface entre la première et la deuxième zone 210, 310, et la deuxième zone 310 présentant une faible concentration en porteurs majoritaires vis-à-vis de la première zone 210, la chute de potentiel se répartit principalement le long de la deuxième zone 310 semiconductrice.

Lorsqu'un photon d'un rayonnement électromagnétique dont la longueur d'onde est comprise dans la gamme de longueurs d'ondes donnée pénètre dans la première zone 210, son absorption génère dans la première zone 210 une paire électron-trou. L'électron et le trou ainsi générés sont séparés l'un de l'autre par le champ électrique présent dans la structure, et l'électron transite vers la deuxième zone 310 semiconductrice.

Dans la deuxième zone 310, en raison du matériau qui la compose et du champ électrique qui y règne, l'électron va produire un nombre multiple d'ionisations par impact et donc former un courant de multiples électrons qui est ensuite collecté par la troisième zone 410.

La structure présentant, de par sa quatrième zone 510, une bonne délimitation de sa deuxième zone 310, le trajet de l'électron dans la deuxième zone est bien défini. Ainsi, le gain de multiplication des électrons dans la deuxième zone 310 étant directement dépendant du trajet, il en résulte que le courant obtenu pour un électron généré dans la première zone 210 est bien défini. De plus, la quatrième zone 510 présentant une bonne interface avec la deuxième zone 310, le courant d'obscurité reste contenu et permet donc d'obtenir un rapport signal sur bruit de bonne qualité.

La figure 2 illustre une structure 1 selon un deuxième mode de réalisation de l'invention. Une structure selon ce deuxième mode de réalisation se différencie d'une structure 1 selon le premier mode de réalisation en ce que la couche d'adaptation 610 comporte la totalité de la troisième zone 410 et donc que la deuxième couche 300 semiconductrice ne comprend pas de partie de la troisième zone 410.

Dans une telle structure 1, la troisième zone 410 est entièrement incluse dans la couche d'absorption 610. La troisième zone 410 est en contact avec la deuxième zone 310 par l'intermédiaire de sa mineure partie 330.

Le procédé de fabrication d'une structure 1 selon ce deuxième mode de réalisation se différencie d'un procédé de fabrication d'une structure 1 selon le premier mode de réalisation en ce que, lors de l'étape d'implantation sélective pour former la troisième zone 410, seule une portion de la couche d'absorption 610 est implantée.

Le principe de fonctionnement d'une structure 1 selon le deuxième mode de réalisation est sensiblement identique à celui d'une structure 1 selon le premier mode de réalisation.

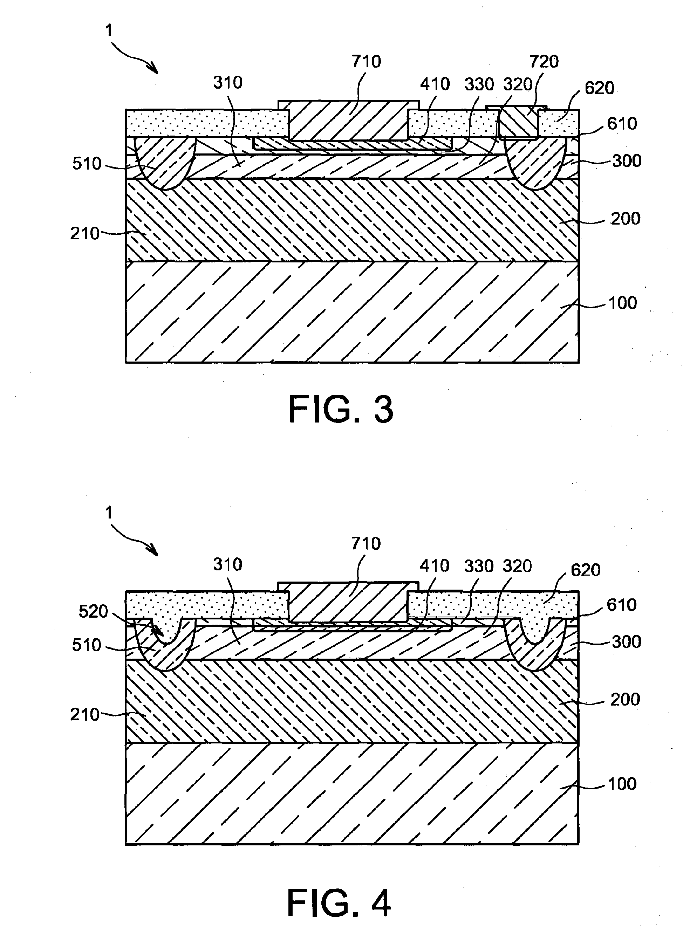

La figure 3 illustre une structure 1 selon un troisième mode de réalisation dans lequel la polarisation de la première zone 210 est obtenue au travers de la quatrième zone 510. Une structure selon ce troisième mode de réalisation se différencie d'une structure 1 selon le deuxième mode de réalisation en ce que le deuxième moyen de polarisation comporte un deuxième contact électrique 720 en contact électrique avec la quatrième zone 510.

Selon ce troisième mode de réalisation, la couche de passivation 620 comporte une deuxième ouverture traversante en communication avec la quatrième zone 510. Le deuxième contact électrique est 720 en contact avec la quatrième zone 510 au travers de l'ouverture aménagée dans la couche de passivation 620.

Le deuxième contact électrique 720 est formé dans un matériau conducteur, généralement métallique, qui est adapté pour former un contact ohmique avec la quatrième zone 510. Ainsi, la quatrième zone 510 de par sa concentration en porteurs majoritaires, significativement supérieure à celle de la deuxième zone 310, permet de contacter électriquement le deuxième contact électrique 720 avec la première zone 210.

Dans ce troisième mode de réalisation, le deuxième contact électrique 720 et la quatrième zone 510 forment ensemble le deuxième moyen de polarisation.

Un procédé de fabrication d'une structure 1 selon se troisième mode de réalisation se différencie d'un procédé de fabrication d'une structure 1 selon le deuxième mode de réalisation en ce que l'étape de formation du deuxième moyen de polarisation comporte les sous-étapes consistant à :
- former une deuxième ouverture traversante dans la couche de passivation 620 en communication avec la quatrième zone 510,
- former le deuxième contact électrique 720 au travers de la deuxième ouverture de la couche de passivation 620 et en contact électrique avec la quatrième zone semiconductrice 510.

Une structure 1 semiconductrice selon ce troisième mode de réalisation présente un principe de fonctionnement sensiblement identique à celui d'une structure selon le premier mode de réalisation.

La figure 4 illustre une structure 1 selon un quatrième mode de réalisation dans laquelle une cavité 520 est aménagée dans la couche d'adaptation 610 et la deuxième couche 300 semiconductrice au niveau de la quatrième zone 510. Une structure 1 selon ce quatrième mode de réalisation se différencie d'une structure 1 selon le premier mode de réalisation en ce que la couche d'adaptation 610 et la deuxième couche 300 semiconductrice comporte une cavité 520 au niveau de la quatrième zone 510, la quatrième zone 510 s'étendant de part et d'autre de cette cavité 520.

La cavité 520 traverse la totalité de la couche d'adaptation 610 et traverse partiellement la deuxième couche 300 semiconductrice. La cavité 520 entoure latéralement la deuxième zone 310 sur une partie de son épaisseur.

Dans ce mode de réalisation, la quatrième zone 510 s'étend de part et d'autre de la cavité 520 de manière à ce que la quatrième zone 510 forme une interface entre la deuxième zone 310 et la cavité 520. La quatrième zone 510 est notamment comprise entre la cavité 520 et la deuxième zone 310.

Un procédé de fabrication d'une structure 1 selon le quatrième mode de réalisation se différencie d'une structure 1 selon le premier mode de réalisation en ce que, entre l'étape de formation de la couche d'adaptation 610 et l'étape d'implantation des portions de la deuxième couche 200 semiconductrice et de la couche d'adaptation 610 qui sont destinées à former la quatrième zone 510, il est en outre prévu une étape consistant à :
- graver sélectivement la couche d'adaptation 610 et la deuxième couche 200 semiconductrice de manière à former la cavité 520.

Une structure 1 selon le quatrième mode de réalisation présente un principe de fonctionnement sensiblement identique à celui d'une structure 1 selon le premier mode de réalisation.

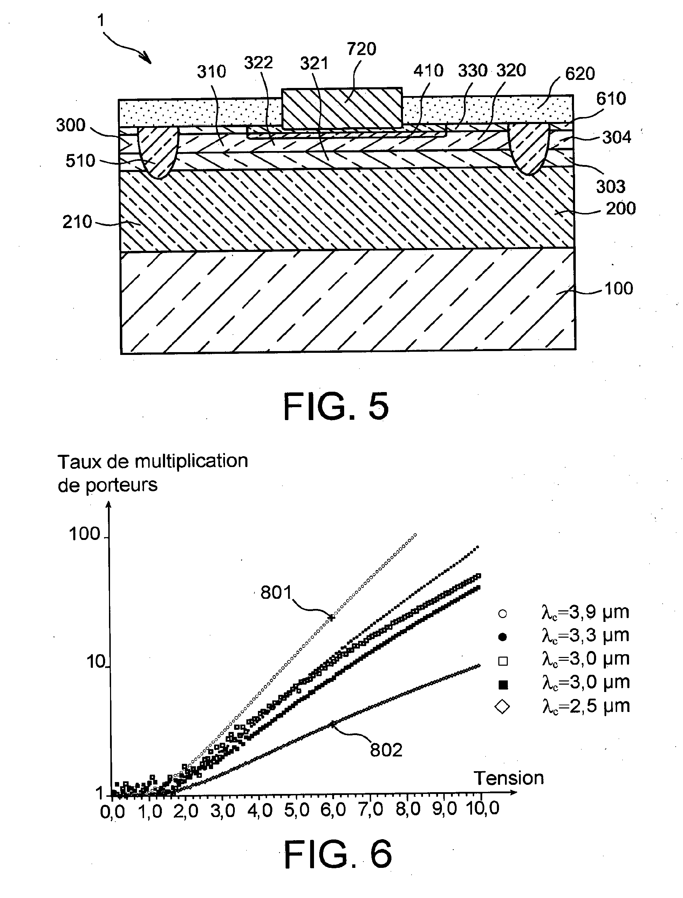

La figure 5 illustre une structure 1 selon un cinquième mode de réalisation dans lequel la deuxième zone 310 comporte une première et une seconde sous-partie 321, 322 adaptées pour que la seconde sous-partie 322 présente un taux moyen de multiplication de porteurs par micromètre supérieur d'au moins cinq fois celui de la première sous-partie. Une structure selon le cinquième mode de réalisation se différencie d'une structure selon le premier mode de réalisation en ce que la deuxième zone est adaptée pour fournir une multiplication de porteurs par ionisation par impact qui est prépondérante pour un type de porteurs et en ce qu'elle comporte une première et une seconde sous-partie formées respectivement dans une première et une seconde sous-couche 303, 304 de la deuxième couche 300 semiconductrice.

Dans ce cinquième mode de réalisation, la deuxième couche 300 comporte une première et une deuxième sous-couche 303, 304. La première et la deuxième sous-couche 303, 304 sont les sous-couches par lesquelles la deuxième couche 300 est en contact respectif avec la première couche 200 semiconductrice et la couche d'adaptation 610.

La première et la deuxième sous-couche 303, 304 comportent respectivement la première et la deuxième sous-partie 321, 322 de la majeure partie 320 de la deuxième zone 310.

La première et la deuxième sous-couche sont adaptées de manière à ce que la deuxième sous-partie 322 présente un taux moyen de multiplication de porteurs par micromètre supérieur à celui de la première sous-partie 321, préférentiellement supérieur à 3 fois, 5 fois, voire 10 fois à celui de la première sous partie 321. A cet effet, la deuxième sous-couche 304 comporte une largeur de bande interdite inférieure à celle de la première sous-couche 303.

Les valeurs du rapport de taux moyen de multiplication de porteurs par micromètre données ci-dessus s'entendent en fonctionnement de la structure. La structure est considérée en fonctionnement lors de sa polarisation à une tension nominale de fonctionnement, telle que par exemple 12 V.

De même, pour une première et une deuxième sous partie 321,322 présentant des épaisseurs du même ordre de grandeur, ou préférentiellement sensiblement identiques, un rapport de multiplication de porteurs entre lesdites première et deuxième sous-parties 321,322 est équivalent au rapport de taux moyen de porteurs par micromètre entre ces deux mêmes sous-parties 321,322. Ainsi, dans cette configuration des première et deuxième sous-parties, la deuxième sous-partie 322 présente un taux de multiplication de porteurs au moins supérieur à 3 fois, 5 fois, préférentiellement 10 fois, au taux moyen de multiplication de porteurs de la première sous-partie 321.

La figure 6 illustre ainsi graphiquement la variation du taux de multiplication de porteurs d'une zone de multiplication en tellurure de mercure-cadmium d'une structure en fonction à la fois de la longueur d'onde de coupure λ_{c} de ladite zone, qui correspond directement à la de sa largueur de bande interdite de cette même zone, et de la tension de polarisation de la structure. Cette figure 6 est issue d'un article de J. Rothman et Al. publié dans la revue scientifique Journal of « Electronic Materials » n°42 p2928 en 2012. Pour une structure comportant une première et une deuxième sous-partie 321, 322 présentant chacune les caractéristiques identiques à celle d'une zone de multiplication de la figure 6 et pour une tension de polarisation de 12 V appliquée à la structure, la chute de tension va se répartir de façon équivalente le long des deux sous-parties 321, 322. Ainsi, les taux de multiplication le long de telles première et deuxième sous-parties avec une telle tension de polarisation correspondent à ceux de zones de multiplication selon la figure 6 qui comportent les mêmes longueurs d'onde de coupure λ_{c} à la tension de polarisation de la structure divisée par deux, c'est-à-dire une tension de 6 V.

Ainsi, par exemple pour une première sous-partie 321 dont la longueur de coupure λ_{c} est de 2,5 µm, ce qui correspond à une largeur de bande interdite de 0,45 eV et une deuxième sous-partie 322 dont la longueur d'onde de coupure λ_{c} est de 3,9 µm, ce qui correspond à une largeur de bande interdite de 0,32 eV, les taux de multiplication sont respectivement de 2 (voir le point 802 sur la figure 4) et de 20 (voir le point 801 sur la figure 4). On obtient donc des rapports de taux de multiplication de porteurs entre la première et la deuxième sous-partie 321, 322 et de taux moyens de multiplication de porteurs entre ces deux mêmes parties égaux à 10.

Afin d'obtenir ces conditions, dans l'application particulière, la première et la deuxième sous-couche 303, 304 sont toutes deux réalisées dans un tellurure de mercure-cadmium du type CdₓHg₁₋ₓTe avec des proportions x₁, x₂ de cadmium respectivement comprises entre 0,6 et 0,33, et entre 0,42 et 0,2. Les épaisseurs de la première et de la deuxième sous-couche 303, 304 sont respectivement comprises entre 0,5 et 1 µm et entre 0,5 et 2 µm. La première et la deuxième sous-couche présentent un second type de conductivité dont les porteurs majoritaires sont des électrons. Les concentrations en porteurs majoritaires de la première et de la seconde sous-couche sont sensiblement identiques et sont comprises entre 10¹⁴ et 10¹⁵ cm⁻³.

Dans l'application particulière, la première et la deuxième sous-couche 303, 304 sont toutes deux réalisées dans un tellurure de mercure-cadmium du type CdₓHg₁₋ₓTe avec des proportions de cadmium respectivement comprises entre 0,6 et 0,4, et entre 0,42 et 0,2. Les épaisseurs respectives de la première et de la deuxième sous-couche sont respectivement comprises entre 0,5 et 1 µm et entre 0,5 et 2 µm. La première et la deuxième sous-couche présentent un second type de conductivité dont les porteurs majoritaires sont des électrons. La concentration en porteurs majoritaires de la première et celle de la seconde sous-couche sont sensiblement identiques et sont comprises entre 10¹⁴ et 10¹⁵ cm⁻³.

Selon cette possibilité de l'invention, la largeur de bande interdite de la deuxième sous-couche 304 peut être adaptée pour autoriser l'absorption du rayonnement électromagnétique par la deuxième sous-couche 304 dans une deuxième gamme de longueurs d'ondes dont l'énergie est inférieure à la gamme de longueurs d'ondes donnée. Avec une telle possibilité, la structure 1 permet, en fonctionnement la détection et la mesure d'un rayonnement dont la longueur d'onde est comprise dans la deuxième gamme de longueur en complément de la mesure de rayonnements à la longueur d'onde donnée.

Selon cette possibilité appliquée à l'application particulière la proportion en cadmium de la deuxième sous-couche peut être comprise entre 0,32 et 0,2 pour fournir une deuxième gamme de longueurs d'ondes comprenant le rayonnement thermique.

Un procédé de fabrication d'une structure selon ce cinquième mode de réalisation se différencie d'un procédé de fabrication d'une structure selon le premier mode de réalisation en ce que l'étape de formation de la deuxième couche consiste à :
- former, en contact avec la deuxième face 202 de la première couche 200, la deuxième couche 300 semiconductrice, la deuxième couche 300 étant du deuxième type de conductivité et comportant une première et une seconde face 301, 302, la deuxième couche 300 étant en contact avec la première couche 200 par sa première face longitudinale 301, lors de cette étape de formation la composition de la couche étant variée de manière à former la première et la deuxième sous-couche 303, 304.

Selon une alternative de ce mode de réalisation non illustrée, la première et la deuxième couche 303, 304 sont séparées l'une de l'autre par une zone d'interface du premier type de conductivité dont la concentration en porteurs majoritaires est adaptée pour modifier la répartition du champ électrique dans la deuxième sous-partie afin que cette dernière présente un taux moyen de multiplication de porteurs par micromètre supérieur à celui de la première sous-partie, la deuxième sous-partie présentant un taux moyen de multiplication de porteurs par micromètre supérieur à au moins 3 fois et préférentiellement 5 fois, voire 10 fois, celui de la première sous-partie.. Selon cette alternative, la première et la deuxième sous-couche 303, 304 présentent des largeurs de bande interdite sensiblement identiques et sont du deuxième type de conductivité avec une concentration en porteurs majoritaires du même ordre de grandeur.

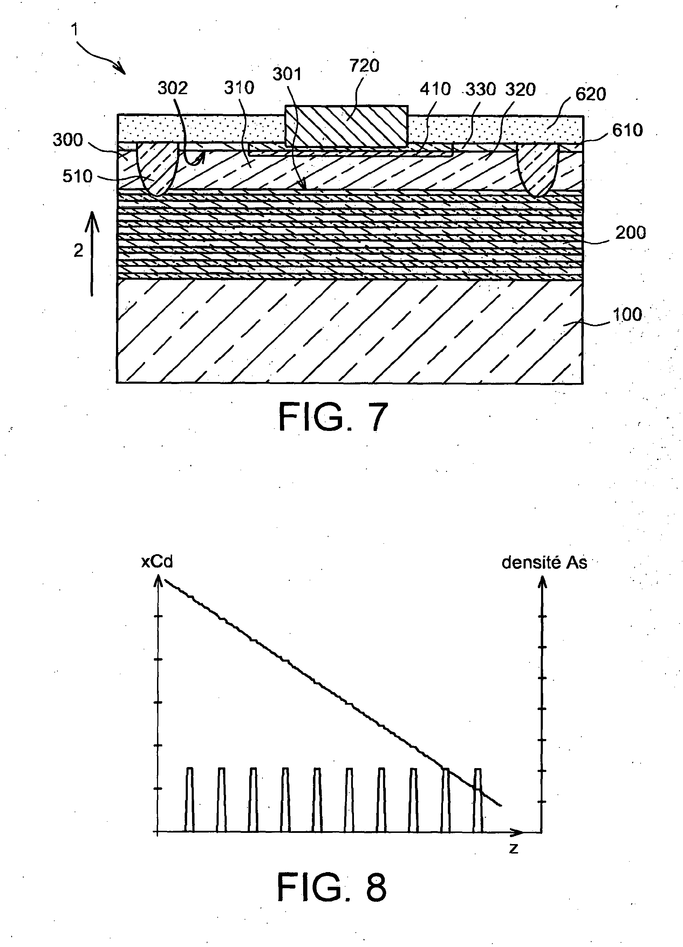

La figure 7 illustre une structure 1 selon un sixième mode de réalisation dans lequel la première couche semiconductrice 200 comporte de l'arsenic dont la concentration est variée alternativement dans une direction sensiblement perpendiculaire à la première face longitudinale 301 entre une concentration dite faible et une concentration dite forte.

Une structure 1 selon ce sixième mode de réalisation se différencie d'une structure 1 selon le premier mode de réalisation en ce qu'elle comporte une première zone 210 comportant un élément dopant adapté fournissant au moins un porteur majoritaire correspondant au premier type de conductivité, tel que de l'arsenic, dont la concentration est variée, comme cela est illustré sur la figure 8, alternativement dans la direction perpendiculaire à la longueur entre une concentration dite faible et une concentration dite forte et en ce que cette même première zone 210 est formée en tellurure de mercure-cadmium du type CdₓHg₁₋ₓTe avec une proportion de cadmium x qui est variée.

Ledit élément dopant étant préférentiellement de l'arsenic, seul ce dernier est mentionné ci-dessous. En alternative à l'arsenic, la première couche 200 peut comporter un autre élément dopant, tel que l'or Au ou l'antimoine Sb, selon une configuration similaire à celle décrite ci-dessous.

Dans ce sixième mode de réalisation, la première couche 200 présente une épaisseur comprise entre 0,5 et 2 µm.

La première couche 200 est d'un premier type de conductivité pour lequel les porteurs majoritaires sont des électrons.

Les porteurs majoritaires dans la première couche 200 sont fournis au moyen de l'élément dopant qui est l'arsenic. La concentration en arsenic le long de la première couche 200 est variée alternativement le long de l'épaisseur de la première couche entre une concentration dite faible et une concentration dite forte. L'alternance entre la concentration faible et la concentration forte est sensiblement périodique.

Chaque période comporte une première partie correspondant à la concentration forte et une deuxième partie correspondant à la concentration faible avec un rapport dimensionnel entre la première partie et la deuxième partie selon la direction perpendiculaire à la longueur qui est au maximum de 10 et typiquement inférieure à 5.

La concentration dite faible est sensiblement nulle pour limiter les risques de diffusion du cadmium le long de l'épaisseur de la première couche, ainsi les parties de la zone présentant une concentration de type faible sont du type intrinsèque.

La concentration en arsenic dite forte est suffisante pour que les porteurs fournis par les parties correspondant à la concentration forte influencent les parties correspondant à la concentration faible. Ainsi la concentration en arsenic est adaptée pour que la concentration en porteurs majoritaires d'un matériau comportant une telle concentration en arsenic soit supérieure à 20 fois celle de ce même matériau lorsqu'il est du type intrinsèque.

Dans la première couche semiconductrice, la concentration en arsenic dite forte, la période et le rapport dimensionnel entre une partie correspondant à la concentration forte et une partie correspondant à la concentration faible selon la direction sensiblement perpendiculaire à la première face longitudinale 301 sont adaptés pour que la concentration en porteurs majoritaires dans la première couche présente une faible résistance série.

Selon une possibilité préférée de ce sixième mode de réalisation, la première zone 210 est en contact avec la deuxième zone 310 par une région sensiblement dépourvue d'arsenic. Selon cette même possibilité, la région de la première zone 210 par laquelle la première zone 210 est en contact avec la deuxième zone 310 peut comporter une proportion x en cadmium qui est variée en direction de la deuxième zone 310.

Un procédé de fabrication d'une structure 1 selon ce sixième mode de réalisation se différencie d'un procédé de fabrication d'une structure 1 selon le premier mode de réalisation en ce que l'étape de fourniture du support consiste à :
- fournir un support 100 semiconducteur et la première couche 200 semiconductrice, la première couche 200 semiconductrice étant du premier type de conductivité avec une concentration en arsenic qui est varié alternativement entre la concentration forte et la concentration faible, la première couche comportant une première et une seconde face 201, 202.

## Revendications

1. Structure (1) semiconductrice de type photodiode à avalanche destinée à recevoir un rayonnement électromagnétique dans une gamme de longueurs d'onde donnée et comportant :
- une première zone (210) semiconductrice, dite d'absorption, d'un premier type de conductivité présentant une première face (201) destinée à recevoir le rayonnement électromagnétique et une seconde face (202) opposée à la première face (201), le matériau semiconducteur dans lequel est formée ladite première zone (210) présentant une largeur de bande interdite adaptée pour autoriser l'absorption du rayonnement électromagnétique par ladite première zone (210),
- au moins une deuxième zone (310) semiconductrice, dite de multiplication, en contact sur une première face longitudinale (301) avec la seconde face (201) de la première zone (210), la deuxième zone (310) présentant une concentration en porteurs majoritaires inférieure à celle de la première zone (210), et étant adaptée pour fournir une multiplication des porteurs par ionisation par impact,
- une troisième zone (410) semiconductrice, dite de collecte, en contact avec la deuxième zone (310) semiconductrice, ladite troisième zone (410) étant d'un deuxième type de conductivité opposé au premier type de conductivité et présentant une concentration en porteurs majoritaires supérieure à celle de la deuxième zone (310) semiconductrice,
- un moyen de délimitation adapté pour délimiter la deuxième zone (310) latéralement,
la structure étant **caractérisée en ce que** le moyen de délimitation comporte une quatrième zone (510) semiconductrice entourant la deuxième zone (310) et comportant une largeur de bande interdite d'énergie supérieure à celle d'une majeure partie (320) de la deuxième zone (310), ladite quatrième zone (510) étant du premier type de conductivité avec une concentration en porteurs majoritaires supérieure à celle de la deuxième zone (310).

2. Structure (1) selon la revendication 1, dans laquelle la deuxième et la quatrième zone (310, 510) sont toutes deux essentiellement formées d'au moins trois même éléments, ces au moins trois éléments étant adaptés de manière à ce que la variation de la proportion d'au moins un desdits au moins trois éléments entraîne une variation de largeur de bande interdite, les proportions respectives dudit au moins un élément de la deuxième et de la quatrième zone (310, 510) étant adaptées pour que la quatrième zone (510) présente une largeur de bande interdite supérieure à celle de la deuxième zone (310).

3. Structure (1) selon la revendication précédente, dans laquelle les au moins trois éléments sont le tellure, le cadmium et le mercure, la proportion de cadmium de la deuxième et de la quatrième zone (310, 510) étant adaptées pour que la quatrième zone (510) présente une largeur de bande interdite supérieure à celle de la deuxième zone (310).

4. Structure (1) selon l'une quelconque des revendications précédentes, dans laquelle la structure (1) comporte en outre une couche d'adaptation (610) et une couche de passivation (620), la couche d'adaptation (610) comportant une partie (330), dite mineure, de la deuxième zone (310) et étant en contact avec une partie (320), dite majeure, de la deuxième zone (310), cette même couche d'adaptation (610) présentant une largeur de bande interdite dont l'énergie est comprise entre celle de couche de passivation (620) et celle de la majeure partie (320) de la deuxième zone (310).

5. Structure (1) selon la revendication précédente, dans laquelle la couche d'adaptation (610) est formée dans un tellurure de mercure-cadmium du type CdₓHg₁₋ₓTe dont la proportion x en cadmium est supérieure à celle de la majeure partie (320) de la deuxième zone (310).

6. Structure (1) selon la revendication 4 ou 5, dans laquelle la couche d'adaptation (610) comporte au moins une partie de la troisième zone semiconductrice (410).

7. Structure (1) selon la revendication précédente dans laquelle la couche d'adaptation (610) comporte la totalité de la troisième zone (410).

8. Structure (1) selon l'une quelconque des revendications précédentes, dans laquelle il est prévu un premier et un deuxième moyen de polarisation adaptés pour polariser respectivement la troisième et la première zone (410, 210) semiconductrice, le deuxième moyen de polarisation comportant la quatrième zone (510) et un contact électrique (702) en contact électrique avec la quatrième zone (510), la quatrième zone (510) permettant de connecter électriquement la première zone (210) et le contact électrique (702).

9. Structure (1) selon l'une quelconque des revendications précédentes, dans laquelle le moyen de délimitation comporte en outre une cavité (520) entourant latéralement sur au moins une partie de son épaisseur la deuxième zone (310), la quatrième zone (510) étant comprise entre la cavité (520) et la deuxième zone (310).

10. Structure (1) selon l'une quelconque des précédentes revendication dans laquelle la deuxième zone (310) est adaptée pour fournir une multiplication de porteurs par ionisation par impact qui est prépondérante pour un type de porteurs et négligeable pour l'autre type de porteurs, et dans laquelle la deuxième zone (310) comporte au moins deux sous-parties (321, 322) de sa majeure partie (320), la première sous-partie (321) par laquelle la deuxième zone (310) est en contact avec la première zone (210), la deuxième sous-partie (322) étant adaptée pour présenter un taux moyen de multiplication de porteurs par micromètre supérieur au taux moyen de multiplication de porteurs par micromètre de la première sous-partie (321), et préférentiellement supérieur à 3 fois, 5 fois, voire 10 fois le taux moyen de multiplication de porteurs par micromètre de la première sous-partie (321).

11. Structure (1) selon la revendication précédente, dans laquelle la deuxième sous-partie (322) est réalisée dans un matériau semiconducteur présentant une largeur de bande interdite inférieure à celle du matériau semiconducteur dans lequel est formée la première sous-partie (321) de manière à présenter le taux moyen de multiplication de porteurs par micromètre supérieur à celui de la première sous-partie (321).

12. Structure (1) selon l'une quelconque des revendications précédente, dans laquelle le matériau semiconducteur dans lequel est formée la première zone (210) est un tellurure de mercure-cadmium dont la composition en cadmium est variée pour favoriser l'absorption du rayonnement, et dans laquelle la première zone (210) comporte un élément dopant fournissant au moins un porteur majoritaire correspondant au premier type de conductivité" la concentration en ledit élément dopant étant variée alternativement dans une direction sensiblement perpendiculaire à la première face longitudinale (301) entre une concentration dite faible et une concentration dite forte.

13. Structure (1) selon l'une quelconque des revendications précédentes dans laquelle, la structure (1) est en outre destinée à recevoir un rayonnement électromagnétique dans une deuxième gamme de longueurs d'ondes d'énergies inférieurs à celles de la première gamme de longueurs d'ondes, la majeure partie (320) de la deuxième zone (310) comportant une sous-partie (322) présentant une largeur de bande interdite inférieure à celle de la première zone (210) semiconductrice et qui est adaptée pour favoriser l'absorption du rayonnement électromagnétique dans la deuxième gamme de longueurs d'ondes.

14. Procédé de fabrication d'une structure (1) du type photodiode à avalanche selon la revendication 1, ledit procédé comportant les étapes consistant à :
- fournir un support comportant une première zone (210) semiconductrice d'un premier type de conductivité présentant une première face (201) destinée à recevoir le rayonnement électromagnétique et une seconde face (202) opposée à la première face (201), le matériau semiconducteur dans lequel est formée ladite première zone (210) présentant une largeur de bande interdite adaptée pour autoriser l'absorption du rayonnement électromagnétique dans ladite première zone (210),
- former au moins une deuxième zone (310) semiconductrice en contact sur une première face longitudinale (301) avec la seconde face (202) de la première zone (210), la deuxième zone (310) présentant une concentration en porteurs majoritaires inférieure à celle de la première zone (210),
- former une troisième zone (410) semiconductrice en contact avec la deuxième zone (310) semiconductrice, ladite troisième zone (410) étant d'un deuxième type de conductivité opposé au premier type de conductivité et présentant une concentration en porteurs majoritaires supérieure que celle de la deuxième zone (310) semiconductrice,
- former une quatrième zone (510) semiconductrice entourant la deuxième zone (310) et comportant une largeur de bande interdite supérieure à la largeur de bande interdite de la majeure partie (211) de la deuxième zone (310), ladite quatrième zone (510) étant du premier type de conductivité avec une concentration en porteurs majoritaires supérieure à celle de la deuxième zone (310), ladite quatrième zone formant un moyen de délimitation de la deuxième zone.

15. Procédé de fabrication selon la revendication précédente, la structure (1) comportant une couche d'adaptation (610), les première et quatrième zone (210, 510) ainsi que la couche d'adaptation (610) étant formées dans des tellurures de mercure-cadmium du type CdₓHg₁₋ₓTe, l'étape de formation de la deuxième zone (310) comporte les sous-étapes consistant à :
- former la couche d'adaptation (610) en contact avec une majeure partie (320) de la deuxième zone (310) semiconductrice, la proportion x de cadmium étant adaptée pour que la couche d'adaptation présente une largeur de bande interdite supérieure à celle de la deuxième zone (310),
- implanter les portions de la structure (1) destinée à former la quatrième zone (510) avec de l'arsenic de manière à fournir une concentration en porteurs majoritaires supérieure à celle de la deuxième zone (310) semiconductrice,
- faire un recuit d'activation de manière à faire diffuser une partie du cadmium à partir de la couche d'adaptation dans lesdites portions de la structure (1) de manière à former la quatrième zone (510).

## Patentansprüche

1. Halbleiterstruktur (1) vom Typ Lawinen-Fotodiode, die dazu bestimmt ist, eine elektromagnetische Strahlung in einem gegebenen Wellenlängenbereich zu empfangen und enthält:
- einen ersten Halbleiterbereich (210), Absorptionsbereich genannt, mit einem ersten Leitungstyp, der eine erste Seite (201) aufweist, die dazu bestimmt ist, die elektromagnetische Strahlung zu empfangen, sowie eine der ersten Seite (201) entgegengesetzte zweite Seite (202), wobei das Halbleitermaterial, aus dem der erste Bereich (210) gebildet ist, eine Bandlücke aufweist, die dazu ausgelegt ist, die Absorption der elektromagnetischen Strahlung über den ersten Bereich (210) zu gestatten,
- zumindest einen zweiten Halbleiterbereich (310), Multiplikationsbereich genannt, der auf einer ersten Längsseite (301) in Kontakt mit der zweiten Seite (201) des ersten Bereichs (210) ist, wobei der zweite Bereich (310) eine Konzentration an Majoritätsträgern aufweist, die niedriger als die des ersten Bereichs (210) ist, und dazu geeignet ist, eine Multiplikation von Trägern durch Stoßionisation zu erbringen,
- einen dritten Halbleiterbereich (410), Sammelbereich genannt, der mit dem zweiten Halbleiterbereich (310) in Kontakt steht, wobei der dritte Bereich (410) von einem zweiten Leitungstyp ist, welcher dem ersten Leitungstyp entgegengesetzt ist, und eine Konzentration an Majoritätsträgern aufweist, die höher als die des zweiten Halbleiterbereichs (310) ist,
- eine Begrenzungseinrichtung, die dazu geeignet ist, den zweiten Bereich (310) seitlich zu begrenzen,
wobei die Struktur **dadurch gekennzeichnet ist, dass** die Begrenzungseinrichtung einen vierten Halbleiterbereich (510) aufweist, der den zweiten Bereich (310) umgibt und eine Bandlücke mit einer Energie aufweist, die höher als die eines größeren Teils (320) des zweiten Bereichs (310) ist, wobei der vierte Bereich (510) vom ersten Leitungstyp mit einer Konzentration an Majoritätsträgern ist, die höher als die des zweiten Bereichs (310) ist.

2. Struktur (1) nach Anspruch 1, wobei der zweite und der vierte Bereich (310, 510) beide im Wesentlichen aus zumindest drei gleichen Elementen gebildet sind, wobei diese zumindest drei Elemente so ausgelegt sind, dass die Änderung des Anteils zumindest eines der zumindest drei Elemente zu einer Änderung der Bandlücke führt, wobei die jeweiligen Anteile des zumindest einen Elements des zweiten und des vierten Bereichs (310, 510) dazu ausgelegt sind, dass der vierte Bereich (510) eine Bandlücke aufweist, die größer als die des zweiten Bereichs (310) ist.

3. Struktur (1) nach dem vorangehenden Anspruch, wobei die zumindest drei Elemente Tellur, Cadmium und Quecksilber sind, wobei der Cadmium-Anteil des zweiten und des vierten Bereichs (310, 510) so ausgelegt ist, dass der vierte Bereich (510) eine Bandlücke aufweist, die größer als die des zweiten Bereichs (310) ist.

4. Struktur (1) nach einem der vorangehenden Ansprüche, wobei die Struktur (1) ferner eine Anpassungsschicht (610) und eine Passivierungsschicht (620) aufweist, wobei die Anpassungsschicht (610) einen sogenannten kleineren Teil (330) des zweiten Bereichs (310) aufweist und in Kontakt mit einem sogenannten größeren Teil (320) des zweiten Bereichs (310) steht, wobei diese gleiche Anpassungsschicht (610) eine Bandlücke mit einer Energie aufweist, die zwischen derjenigen der Passivierungsschicht (620) und derjenigen des größeren Teils (320) des zweiten Bereichs (310) liegt.

5. Struktur (1) nach dem vorangehenden Anspruch, wobei die Anpassungsschicht (610) aus Quecksilber-Cadmium-Tellurid vom Typ CdₓHg₁₋ₓTe gebildet ist, dessen Cadmium-Anteil x höher als der des größeren Teils (320) des zweiten Bereichs (310) ist.

6. Struktur (1) nach Anspruch 4 oder 5, wobei die Anpassungsschicht (610) zumindest einen Teil des dritten Halbleiterbereichs (410) aufweist.

7. Struktur (1) nach dem vorangehenden Anspruch, wobei die Anpassungsschicht (610) den gesamten dritten Bereich (410) aufweist.

8. Struktur (1) nach einem der vorangehenden Ansprüche, wobei eine erste und eine zweite Polarisierungseinrichtung vorgesehen ist, die dazu geeignet sind, den dritten bzw. den ersten Halbleiterbereich (410, 210) zu polarisieren, wobei die zweite Polarisierungseinrichtung den vierten Bereich (510) und ein elektrisches Kontaktstück (702) aufweist, das elektrisch mit dem vierten Bereich (510) in Kontakt steht, wobei der vierte Bereich (510) gestattet, den ersten Bereich (210) und das elektrische Kontaktstück (702) elektrisch zu verbinden.

9. Struktur (1) nach einem der vorangehenden Ansprüche, wobei die Begrenzungseinrichtung ferner einen Hohlraum (520) aufweist, der zumindest über einen Teil seiner Dicke den zweiten Bereich (310) seitlich umgibt, und wobei der vierte Bereich (510) zwischen dem Hohlraum (520) und dem zweiten Bereich (310) liegt.

10. Struktur (1) nach einem der vorangehenden Ansprüche, wobei der zweite Bereich (310) dazu geeignet ist, eine Multiplikation der Träger durch Stoßionisation zu erbringen, die für einen Trägertyp überwiegend und für den anderen Trägertyp vernachlässigbar ist, und wobei der zweite Bereich (310) zumindest zwei Unterabschnitte (321, 322) seinen größeren Teils (320) aufweist, nämlich einen ersten Unterabschnitt (321), über welchen der zweite Bereich (310) mit dem ersten Bereich (210) in Kontakt steht, wobei der zweite Unterabschnitt (322) dazu geeignet ist, einen mittleren Multiplikationsfaktor zur Multiplikation der Träger pro Mikrometer aufzuweisen, der höher ist als der Trägermultiplikationsfaktor pro Mikrometer des ersten Unterabschnitts (321), vorzugsweise 3 mal, 5 mal bzw. 10 mal so hoch wie der mittlere Trägermultiplikationsfaktor pro Mikrometer des ersten Unterabschnitts (321).

11. Struktur (1) nach dem vorangehenden Anspruch, wobei der zweite Unterabschnitt (322) aus einem Halbleitermaterial hergestellt ist, das eine Bandlücke aufweist, die kleiner als die des Halbleitermaterials ist, aus welchem der erste Unterabschnitt (321) gebildet ist, so dass sie den mittleren Trägermultiplikationsfaktor pro Mikrometer aufweist, der höher als derjenige des ersten Unterabschnitts (321) ist.

12. Struktur (1) nach einem der vorangehenden Ansprüche, wobei das Halbleitermaterial, aus dem der erste Bereich (210) gebildet ist, ein Quecksilber-Cadmium-Tellurid ist, dessen Cadmium-Zusammensetzung sich ändert, um die Absorption der Strahlung zu begünstigen, und wobei der erste Bereich (210) ein Dotierungselement aufweist, das zumindest einen Majoritätsträger bereitstellt, der dem ersten Leitungstyp entspricht, wobei die Konzentration an Dotierungselement sich abwechselnd in einer Richtung im Wesentlichen senkrecht zur ersten Längsseite (301) zwischen einer sogenannten schwachen Konzentration und einer sogenannten starken Konzentration ändert.

13. Halbleiterstruktur (1) nach einem der vorangehenden Ansprüche, wobei die Struktur (1) ferner dazu bestimmt ist, eine elektromagnetische Strahlung in einem zweiten Wellenlängenbereich zu empfangen, dessen Energie geringer als die des ersten Wellenlängenbereichs ist, wobei der größere Teil (320) des zweiten Bereichs (310) einen Unterabschnitt (322) aufweist, der eine Bandlücke aufweist, die geringer als diejenige des ersten Halbleiterbereichs (210) ist, und dazu geeignet ist, die Absorption der elektromagnetischen Strahlung in dem zweiten Wellenlängenbereich zu begünstigen.

14. Verfahren zum Herstellen einer Struktur (1) vom Typ Lawinen-Fotodiode nach Anspruch 1, wobei das Verfahren die nachfolgenden Schritte umfasst:
- Bereitstellen eines Trägers mit einem ersten Halbleiterbereich (210) eines ersten Leitungstyps, der eine erste Seite (201) aufweist, die dazu bestimmt ist, die elektromagnetische Strahlung zu empfangen, sowie eine der ersten Seite (201) entgegengesetzte zweite Seite (202), wobei das Halbleitermaterial, aus dem der erste Bereich (210) gebildet ist, eine Bandlücke aufweist, die dazu ausgelegt ist, die Absorption der elektromagnetischen Strahlung in dem ersten Bereich (210) zu gestatten,
- Bilden zumindest eines zweiten Halbleiterbereichs (310), der auf einer ersten Längsseite (301) mit der zweiten Seite (202) des ersten Bereichs (210) in Kontakt steht, wobei der zweite Bereich (310) eine Konzentration an Majoritätsträgern aufweist, die niedriger als die des ersten Bereichs (210) ist,
- Bilden eines dritten Halbleiterbereichs (410), der mit dem zweiten Halbleiterbereich (310) in Kontakt steht, wobei der dritte Bereich (410) von einem zweiten Leitungstyp ist, welcher dem ersten Leitungstyp entgegengesetzt ist und eine Konzentration an Majoritätsträgern aufweist, die höher als die des zweiten Halbleiterbereichs (310) ist,
- Bilden eines vierten Halbleiterbereichs (510), der den zweiten Bereich (310) umgibt und eine Bandlücke aufweist, die größer als die Bandlücke des größeren Teils (211) des zweiten Bereichs (310) ist, wobei der vierte Bereich (510) vom ersten Leitungstyp mit einer Konzentration an Majoritätsträgern ist, die höher als die des zweiten Bereichs (310) ist, wobei der vierte Bereich eine Begrenzungseinrichtung für den zweiten Bereich bildet.

15. Herstellungsverfahren nach dem vorangehenden Anspruch, wobei die Struktur (1) eine Anpassungsschicht (610) aufweist, wobei der erste und der vierte Bereich (210, 510) sowie die Anpassungsschicht (610) aus Quecksilber-Cadmium-Telluriden vom Typ CdₓHg₁₋ₓTe gebildet sind, wobei der Schritt des Bildens des zweiten Bereichs (310) die nachfolgenden Unterschritte umfasst:
- Bilden der Anpassungsschicht (610) in Kontakt mit einem größeren Teil (320) des zweiten Halbleiterbereichs (310), wobei der Cadmium-Anteil x so ausgelegt ist, dass die Anpassungsschicht eine Bandlücke aufweist, die größer als diejenige des zweiten Bereichs (310) ist,
- Implantieren der zum Bilden des vierten Bereichs (510) bestimmten Abschnitte der Struktur (1) mit Arsen, derart, dass eine Konzentration an Majoritätsträgern bereitgestellt wird, die höher als diejenige des zweiten Halbleiterbereichs (310) ist,
- Durchführen eines Aktivierungsglühens derart, dass ein Teil des Cadmiums ausgehend von der Anpassungsschicht in den Abschnitten der Struktur (1) diffundiert, so dass der vierte Bereich (510) gebildet wird.

## Claims

1. Avalanche photodiode-type semiconductor structure (1) intended to receive electromagnetic radiation in a given wavelength and comprising:
- a first semiconductor zone (210), called an absorption zone, with a first type of conductivity having a first face (201) intended to receive the electromagnetic radiation and a second face (202) opposite the first face (201), the semiconductor material in which said first zone (210) is formed having a forbidden energy gap suitable for allowing electromagnetic radiation to be absorbed by said first zone (210),
- at least one second semiconductor zone (310), called a multiplication zone, in contact on a first longitudinal face (301) with the second face (201) of the first zone (210), the second zone (310) having a majority carrier concentration lower than that of the first zone (210), and being suitable for multiplying the carriers by impact ionization,
- a third semiconductor zone (410), called a collection zone, in contact with the second semiconductor zone (310), said third zone (410) having a second type of conductivity opposite the first type of conductivity and having a majority carrier concentration higher than that of the second semiconductor zone (310),
- delimitation means suitable for laterally delimiting the second zone (310),
the structure being **characterized in that** the delimitation means comprise a fourth semiconductor zone (510) surrounding the second zone (310) and comprising a forbidden energy gap of energy higher than that of a major part (320) of the second zone (310), said fourth zone (510) having the first type of conductivity with a majority carrier concentration greater than that of the second zone (310).

2. Structure (1) according to claim 1, wherein the second and fourth zones (310, 510) are both essentially formed by at least three of the same elements, said at least three elements being adapted so that the variation in the proportion of at least one of said at least three elements causes a forbidden energy gap variation, the respective proportions of said at least one element of the second and fourth zones (310, 510) being adapted so that the fourth zone (510) has a forbidden energy gap greater than that of the second zone (310).

3. Structure (1) according to the previous claim, wherein the at least three elements are tellurium, cadmium and mercury, the cadmium proportion of the second and the fourth zones (310, 510) being adapted so that the fourth zone (510) has a forbidden energy gap greater than that of the second zone (310).

4. Structure (1) according to any one of the previous claims, wherein the structure (1) also comprises an adaptation layer (610) and a passivation layer (620), the adaptation layer (610) comprising a part (330), called a minor part, of the second zone (310) and being in contact with a part (320), called a major part, of the second zone (310), this same adaptation layer (610) having a forbidden energy gap of which the energy is between that of the passivation layer (620) and that of the major part (320) of the second zone (310).

5. Structure (1) according to the previous claim, wherein the adaptation layer (610) is made of a mercury-cadmium telluride of the CdₓHg₁₋ₓTe type of which the cadmium proportion x is greater than that of the major part (320) of the second zone (310).

6. Structure (1) according to claim 4 or 5, wherein the adaptation layer (610) comprises at least a part of the third semiconductor zone (410).

7. Structure (1) according to the previous claim, wherein the adaptation layer (610) comprises the entire third zone (410).

8. Structure (1) according to any one of the previous claims, wherein first and second polarization means suitable for polarizing, respectively, the third and the first semiconductor zones (410, 210) are provided, the second polarization means comprising the fourth zone (510) and an electric contact (702) in electrical contact with the fourth zone (510), the fourth zone (510) enabling the first zone (210) and the electric contact (702) to be electrically connected.

9. Structure (1) according to any one of the previous claims, wherein the delimitation means also comprise a cavity (520) laterally surrounding, over at least a part of its thickness, the second zone (310), the fourth zone (510) being between the cavity (520) and the second zone (310).

10. Structure (1) according to any one of the previous claims, wherein the second zone (310) is suitable for providing a carrier multiplication by impact ionization, which is predominant for one type of carrier and negligible for the other type of carrier, and wherein the second zone (310) comprises at least two sub-parts (321, 322) of its major part (320), the first sub-part (321) by which the second zone (310) is in contact with the first zone (210), the second sub-part (322) being adapted so as to have a mean carrier multiplication rate per micrometer greater than the mean carrier multiplication rate per micrometer of the first sub-part (321), and preferably greater than 3 times, 5 times or even 10 times the mean carrier multiplication rate per micrometer of the first sub-part (321).

11. Structure (1) according to the previous claim, wherein the second sub-part (322) is made of a semiconductor material having a forbidden energy gap lower than that of the semiconductor material in which the first sub-part (321) is formed so as to have a mean carrier multiplication rate per micrometer greater than that of the first sub-part (321).

12. Structure (1) according to any one of the previous claims, wherein the semiconductor material of which the first zone (210) is made is a mercury-cadmium telluride of which the cadmium composition is varied so as to promote the absorption of radiation, and wherein the first zone (210) comprises a doping element providing at least one majority carrier corresponding to the first type of conductivity, the concentration of said doping element being varied alternately in a direction substantially perpendicular to the first longitudinal face (301) between a so-called low concentration and a so-called high concentration.

13. Structure (1) according to any one of the previous claims, wherein the structure (1) is also intended to receive electromagnetic radiation in a second wavelength range of energies below those of the first wavelength range, the major part (320) of the second zone (310) comprising a sub-part (322) having a forbidden energy gap lower than that of the first semiconductor zone (210) and which is suitable for promoting the absorption of the electromagnetic radiation in the second wavelength range.

14. Process for producing an avalanche photodiode-type structure (1) according to claim 1, said process comprising the steps consisting of:
- providing a support comprising a first semiconductor zone (210) with a first type of conductivity having a first face (201) intended to receive the electromagnetic radiation and a second face (202) opposite the first face (201), the semiconductor material of which said first zone (210) is made having a forbidden energy gap adapted so as to allow the absorption of the electromagnetic radiation in said first zone (210),
- forming at least one second semiconductor zone (310) in contact on a first longitudinal face (301) with the second face (202) of the first zone (210), the second zone (310) having a majority carrier concentration lower than that of the first zone (210),
- forming a third semiconductor zone (410) in contact with the second semiconductor zone (310), said third zone (410) having a second type of conductivity opposite the first type of conductivity and having a majority carrier concentration greater than that of the second semiconductor zone (310),
- forming a fourth semiconductor zone (510) surrounding the second zone (310) and comprising a forbidden energy gap greater than the forbidden energy gap of the major part (211) of the second zone (310), said fourth zone (510) having the first type of conductivity with a majority carrier concentration greater than that of the second zone (310), said fourth zone forming means for delimiting the second zone.

15. Process according to the previous claim, the structure (1) comprising an adaptation layer (610), the first and fourth zones (210, 510) as well as the adaptation layer (610) being made of mercury-cadmium tellurides of the CdₓHg₁₋ₓTe type, and the step of forming the second zone (310) comprising the sub-steps consisting of:
- forming the adaptation layer (610) in contact with a major part (320) of the second semiconductor zone, the cadmium proportion x being adapted so that the adaptation layer has a forbidden energy gap greater than that of the second zone (310),
- implanting the portions of the structure (1) intended to form the fourth zone (510) with arsenic so as to provide a majority carrier concentration greater than that of the second semiconductor zone (310),
- performing an activation anneal so as to diffuse a part of the cadmium from the adaptation layer in said portions of the structure (1) so as to form the fourth zone (510).
